# FASCICULE DE BREVET EUROPEEN

(11) **EP 2 996 115 B1**
(45) Date de publication et mention de la délivrance du brevet: **11.11.2026**
(21) Numéro de dépôt: 15184324.0
(22) Date de dépôt: 08.09.2015
(51) Int. Cl.: G11C 13/00, G11C 7/14, G11C 7/18

(54) **DISPOSITIF ET PROCÉDÉ D'ÉCRITURE DE DONNÉES DANS UNE MÉMOIRE RÉSISTIVE**
VORRICHTUNG UND VERFAHREN ZUM SCHREIBEN VON DATEN IN EINEN RESISTIVEN SPEICHER
DEVICE AND METHOD FOR WRITING DATA IN A RESISTIVE MEMORY

(30) Priorité: 09.09.2014 FR 1458425
(43) Date de publication de la demande: 16.03.2016
(73) Titulaire: Commissariat à l'Energie Atomique et aux Energies Alternatives, 75015 Paris (FR)
(72) Inventeur: THOMAS, Olivier, 38420 Revel (FR); GIRAUD, Bastien, 38340 Voreppe (FR); HARRAND, Michel, 38120 Saint-Égrève (FR); VIANELLO, Elisa, 38000 Grenoble (FR)
(74) Mandataire: Cabinet Beaumont

(56) Documents cités:
- EP-A2- 1 426 969
- US-A1- 2002 172 073
- US-A1- 2004 004 856
- US-A1- 2007 091 667
- US-A1- 2007 121 368
- US-A1- 2011 157 958
- US-A1- 2012 147 664
- US-A1- 2013 094 277
- US-A1- 2013 235 651
- US-A1- 2014 233 331
- US-B1- 6 317 376
- US-B1- 8 274 842

## Description

### Domaine

La présente demande concerne un dispositif et un procédé d'écriture de données dans une mémoire résistive.

### Exposé de l'art antérieur

Les mémoires résistives sont des mémoires non volatiles comprenant des cellules mémoires ayant chacune au moins un élément résistif pouvant présenter au moins deux valeurs différentes de résistance, par exemple une valeur faible, notée Ron, et une valeur élevée, notée Roff. A titre d'exemple, l'élément résistif peut comprendre un matériau isolant électriquement, une information étant stockée dans l'élément résistif par la présence ou l'absence d'un filament conducteur continu dans le matériau isolant électriquement. Lorsque le filament conducteur est présent, la résistance Ron de l'élément résistif est faible tandis que lorsque le filament est rompu ou est absent, la résistance Roff de l'élément résistif est élevée. Le passage de la résistance de l'élément résistif d'une cellule mémoire de Ron à Roff et inversement est appelé commutation de la cellule mémoire.

On appelle opération d'écriture dans une cellule mémoire le fait de faire passer la résistance de l'élément résistif de la cellule mémoire de Roff à Ron. Une opération d'écriture correspond à la formation du filament conducteur dans l'élément résistif de la cellule mémoire. Ceci peut être obtenu en appliquant une tension déterminée pendant une durée déterminée entre une première borne et une deuxième borne de la cellule mémoire. On appelle opération d'effacement d'une cellule mémoire le fait de faire passer la résistance de l'élément résistif de la cellule mémoire de Ron à Roff. Une opération d'effacement correspond à la rupture du filament de l'élément résistif de la cellule mémoire. Pour une cellule mémoire bipolaire, ceci peut être obtenu en appliquant une tension déterminée pendant une durée déterminée entre la deuxième borne et la première borne de la cellule mémoire, c'est-à-dire avec une polarité inversée par rapport à l'opération d'écriture. Pour une cellule mémoire unipolaire, ceci peut être obtenu en appliquant une tension déterminée ayant une amplitude différente de la tension appliquée pendant l'opération d'écriture. Une opération d'initialisation doit généralement être prévue avant la première opération d'écriture pour former le premier filament en appliquant, entre les première et deuxième bornes, une tension plus importante que celle appliquée au cours d'une opération d'écriture. L'écriture de données dans une mémoire résistive correspond donc à la réalisation d'opérations d'écriture et/ou d'effacement de cellules mémoires de la mémoire résistive.

Un inconvénient des mémoires résistives est que les résistances Ron et Roff obtenues après une opération d'écriture ou une opération d'effacement présentent une variabilité élevée d'une cellule mémoire à l'autre. De plus, pour une même cellule mémoire, la résistance Ron ou Roff peut varier pour deux opérations d'écriture ou d'effacement successives. De ce fait, la détermination de la tension d'écriture ou d'effacement et de la durée d'application de cette tension est difficile. En effet, si la tension d'écriture ou d'effacement est trop faible et/ou si la durée d'application de cette tension est trop courte, certaines cellules mémoires peuvent ne pas commuter. Toutefois, si la tension d'écriture ou d'effacement est trop élevée et/ou si la durée d'application de cette tension est trop longue, certaines cellules mémoires peuvent se détériorer, ce qui entraîne une réduction de la durée de vie de ces cellules mémoires.

Les documents EP 1 426 969, US 2013/235651 et US 2007/121368 décrivent des dispositifs et des procédés d'écriture de données dans une mémoire résistive.

### Résumé

L'invention est définie dans les revendications indépendantes 1 et 10. D'autres modes de réalisation préférés sont définis dans les revendications dépendantes. Seuls les modes de réalisation de la description comprenant toutes les caractéristiques techniques des revendications relèvent du champ d'application de la protection de ces dernières, les autres correspondant à des exemples illustratifs utiles à la compréhension du contexte technique pertinent.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma électrique d'un mode de réalisation d'un dispositif d'effacement d'une mémoire résistive ;
la figure 2 représente des chronogrammes de signaux mis en oeuvre par le dispositif de la figure 1 lors d'une opération d'effacement ;
les figures 3 à 6 sont des schémas électriques de modes de réalisation de parties du dispositif d'effacement de la figure 1 ;
les figures 7 et 8 sont des schémas électriques partiels d'autres modes de réalisation d'un dispositif d'effacement d'une mémoire résistive ;
la figure 9 est un schéma électrique d'un mode de réalisation d'un dispositif d'écriture dans une mémoire résistive ;
la figure 10 représente des chronogrammes de signaux mis en oeuvre par le dispositif de la figure 9 lors d'une opération d'écriture ;
la figure 11 est un schéma électrique d'un autre mode de réalisation d'un dispositif d'écriture dans une cellule mémoire d'une mémoire résistive ;
les figures 12 et 13 sont des schémas électriques de modes de réalisation d'un dispositif d'effacement d'une cellule mémoire d'une mémoire résistive ;
les figures 14 à 16 sont des schémas électriques de modes de réalisation d'un dispositif d'écriture de plusieurs cellules mémoires d'une mémoire résistive ;
la figure 17 est un schéma électrique d'un mode de réalisation d'un dispositif d'écriture et d'effacement de plusieurs cellules mémoires d'une mémoire résistive ;
la figure 18 est un schéma électrique plus détaillé d'un mode de réalisation d'un dispositif d'écriture et d'effacement de cellules mémoires d'une mémoire résistive ; et
les figures 19 à 21 sont des schémas électriques de modes de réalisation d'un dispositif d'effacement/d'écriture de plusieurs cellules mémoires d'une mémoire résistive.

### Description détaillée

Par souci de clarté, de mêmes éléments ont été désignés par de mêmes références aux différentes figures. Dans la suite de la description, les expressions "sensiblement", "environ" et "approximativement" signifient "à 10 % près".

Dans la suite de la description, un signal binaire est un signal qui alterne entre un premier état constant, par exemple un état bas noté "0", et un deuxième état constant, par exemple un état haut noté "1". En pratique, les signaux binaires peuvent correspondre à des tensions ou à des courants qui peuvent ne pas être parfaitement constants à l'état haut ou bas. Les états haut et bas de signaux binaires d'un même circuit électronique peuvent être différents.

Selon un mode de réalisation, une opération d'écriture dans une cellule mémoire d'une mémoire résistive et/ou d'effacement de la cellule mémoire est réalisée de la façon suivante :
- application d'une tension ou d'un courant croissant aux bornes de la cellule mémoire ;
- détection de la commutation de la cellule mémoire ; et
- coupure automatique du courant traversant la cellule mémoire après la détection.

Pour chaque cellule mémoire, la commutation de la cellule mémoire a lieu lorsque la tension appliquée à ses bornes atteint la tension nécessaire à sa commutation. La tension de commutation peut donc être différente d'une cellule mémoire à l'autre. La durée de vie des cellules mémoires est, de façon avantageuse, augmentée puisque chaque cellule mémoire n'est pas soumise, plus longtemps que nécessaire, à la tension ou au courant permettant sa commutation. En outre, la consommation de la mémoire résistive est réduite puisque le courant alimentant chaque cellule mémoire est interrompu dès que la cellule mémoire a commuté.

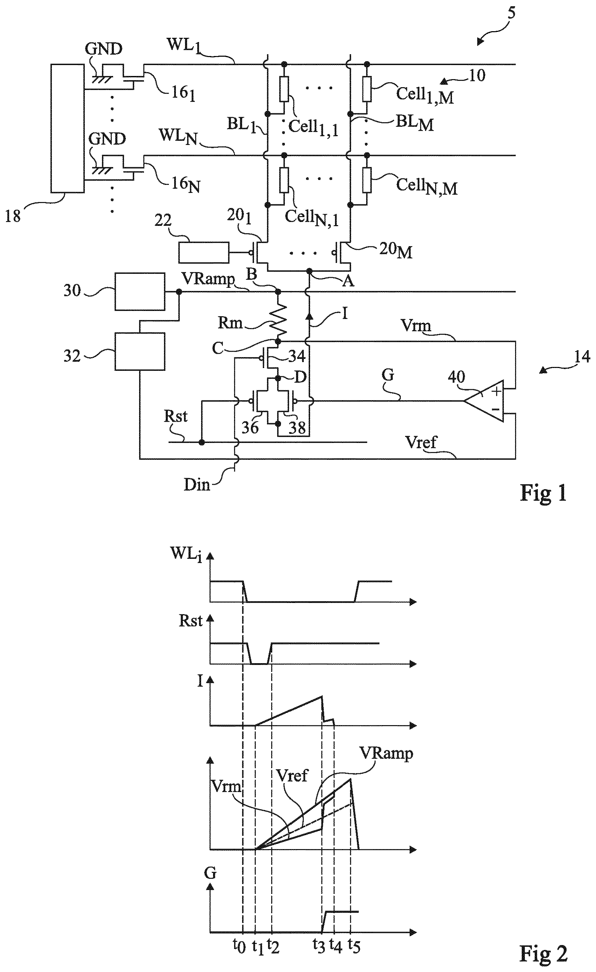

La figure 1 représente un mode de réalisation d'une mémoire résistive 5 comprenant une matrice 10 de cellules mémoires Cell_{i,j}, par exemple sur N rangées et M colonnes, où N et M sont des nombres entiers supérieurs à 2 et où i est un nombre entier qui varie de 1 à N et j est un nombre entier qui varie de 1 à M. La mémoire 5 comprend, en outre, un dispositif 14 d'effacement des cellules mémoires Cell_{i,j}.

Chaque cellule mémoire Cell_{i,j} comprend des première et deuxième bornes. Pour chaque rangée de la matrice 10, les premières bornes des cellules mémoires Cell_{i,j} de la rangée sont reliées à une ligne de mots WLᵢ. Pour chaque colonne de la matrice 10, les deuxièmes bornes des cellules mémoires Cell_{i,j} de la colonne sont reliées à une ligne de bits BLⱼ. Chaque ligne de mot WLᵢ, i variant de 1 à N, est reliée à une source d'un potentiel de référence bas, par exemple la masse GND, par l'intermédiaire d'un interrupteur 16ᵢ. Les interrupteurs 16ᵢ sont commandés par un module 18 de sélection de lignes de mots. A titre d'exemple, chaque interrupteur 16ᵢ correspond à un transistor à effet de champ à grille métal-oxyde, ou transistor MOS, par exemple à canal N, dont le drain est relié à la ligne de mots WLᵢ, dont la source est reliée à la masse GND et dont la grille est commandée par le module 18. Chaque ligne de bits BLⱼ, j variant de 1 à M, est reliée à un interrupteur 20ⱼ. Les interrupteurs 20ⱼ sont commandés par un module 22 de sélection de lignes de bits. A titre d'exemple, chaque interrupteur 20ⱼ correspond à un transistor MOS, par exemple à canal P, dont le drain est relié à la ligne de bits BLⱼ, dont la source est reliée à un noeud A et dont la grille est commandée par le module 22.

A titre d'exemple, chaque cellule mémoire Cell_{i,j} peut comprendre un élément résistif, dans lequel peut être formé un filament conducteur, en série avec un composant non linéaire. Selon un autre exemple, chaque cellule mémoire Cell_{i,j} peut comprendre un élément résistif en série avec un transistor MOS. Dans ce cas, la grille du transistor MOS peut être reliée à la ligne de mots Wᵢ, l'une des bornes de la cellule mémoire Cell_{i,j} étant reliée à la ligne de bits BLⱼ et l'autre borne de la cellule mémoire Cell_{i,j} étant reliée à une source d'un potentiel variable.

Le dispositif d'effacement 14 comprend un circuit 30 de fourniture d'une tension VRamp croissante à un noeud B et un circuit 32 recevant la tension VRamp et fournissant une tension de référence Vref croissante et inférieure à la tension VRamp. A titre d'exemple, le circuit 30 est adapté à fournir une rampe de tension, c'est-à-dire que la tension VRamp est une fonction croissant de façon linéaire en fonction du temps. A titre de variante, la dérivée première par rapport au temps de la tension VRamp diminue dans le temps. A titre d'exemple, la tension VRamp comprend successivement une première rampe et une deuxième rampe, la dérivée première par rapport au temps de la tension VRamp pour la deuxième rampe étant inférieure strictement à la dérivée première par rapport au temps de la tension VRamp pour la première rampe.

Selon un mode de réalisation, la tension Vref est proportionnelle à la tension VRamp avec un rapport de proportionnalité strictement inférieur à 1.

Le dispositif d'effacement 14 comprend une résistance Rm entre le noeud B et un noeud C. La résistance Rm peut être formée par une piste de silicium polycristallin. On appelle Vrm la tension entre le noeud C et la masse GND. Un interrupteur 34 commandé par un signal binaire Din est prévu entre le noeud C et un noeud D. Deux interrupteurs 36 et 38, montés en parallèle, sont prévus entre les noeuds D et A. L'interrupteur 36 est commandé par un signal binaire Rst et l'interrupteur 38 est commandé par un signal binaire G. A titre d'exemple, chaque interrupteur 34, 36, 38 est fermé lorsque le signal de commande associé est dans un premier état, par exemple à l'état bas, et est ouvert lorsque le signal de commande associé est dans un deuxième état, par exemple à l'état haut. Selon un mode de réalisation, chaque interrupteur 34, 36, 38 correspond à un transistor MOS à canal P dont la grille est commandée par le signal de commande associé.

Le dispositif d'effacement 14 comprend un amplificateur opérationnel 40, monté en comparateur, dont l'entrée non inverseuse (+) est reliée au noeud C et reçoit la tension Vrm et dont l'entrée inverseuse (-) est reliée au circuit 32 et reçoit la tension Vref. Le comparateur 40 fournit le signal G. A titre d'exemple, le signal G est à "0" lorsque la tension Vrm est inférieure strictement à la tension Vref et est à "1" lorsque la tension Vrm est supérieure strictement à la tension Vref.

Lorsqu'une cellule mémoire Cell_{i,j} est sélectionnée pour une opération d'effacement, cette cellule mémoire Cell_{i,j} et la résistance Rm forment un pont diviseur de tension. La tension Vrm est donnée par la relation (1) suivante : $Vrm = \frac{RCell}{RCell + Rm} VRamp$ (1) où Rcell est la résistance de la cellule mémoire sélectionnée Cell_{i,j} et est égale à Ron ou Roff.

La résistance Rm est choisie de façon que la tension Vrm soit suffisamment grande pour être mesurable et pas trop élevée pour ne pas gêner les opérations d'écriture ou d'effacement de la cellule mémoire ou imposer une tension Vramp trop élevée. A titre d'exemple, la résistance Rm peut être sensiblement égale à Ron/10. Ensuite, la tension Vref est choisie de sorte que, lorsque la résistance de l'élément résistif de la cellule mémoire Cell_{i,j} sélectionnée est égale à Roff, la tension Vrm est inférieure strictement à la tension Vref et, lorsque la résistance de l'élément résistif de la cellule mémoire Cell_{i,j} est égale à Ron, la tension Vrm est supérieure strictement à la tension Vref.

La matrice mémoire 10 peut être divisée en plusieurs groupes de colonnes. Les colonnes de chaque groupe de colonnes peuvent être reliées à des noeuds A différents et le dispositif d'effacement 14 peut être partiellement dupliqué pour chaque groupe de colonnes. Plus précisément, la résistance Rm, les interrupteurs 34, 36, 38 et le comparateur 40 sont reproduits pour chaque groupe de colonnes et les circuits 30 et 32 peuvent être communs à tous les groupes de colonnes.

La figure 2 représente des chronogrammes de signaux mis en oeuvre par la mémoire 5 de la figure 1 lors d'une opération d'effacement. Les instants t₀ à t₅ sont des instants successifs.

A l'instant t₀, la cellule mémoire Cell_{i,j} dans laquelle une opération d'effacement doit être réalisée est sélectionnée. Ceci est obtenu en reliant la ligne de mots WLᵢ à la masse GND et en rendant passant le transistor 20ⱼ. En outre, le signal Rst est mis à "0", ce qui rend passant le transistor 36. Le signal Din est à "0" lorsqu'une opération d'effacement doit être réalisée dans la cellule mémoire sélectionnée. Le transistor 34 est alors passant.

A l'instant t₁, la tension VRamp commence à croître depuis la valeur nulle. Les tensions Vref et Vrm commencent donc à croître. En outre, un courant I commence à circuler dans la cellule mémoire Cell_{i,j} sélectionnée. La résistance de l'élément résistif de la cellule mémoire Cell_{i,j} étant égale à Ron, la tension Vrm est inférieure strictement à la tension Vref. Le signal G fourni par le comparateur 40 est à "0" dès que l'écart entre les tensions Vrm et Vref est suffisant. La valeur du signal G pouvant être incertaine tant que les tensions Vrm et Vref ne sont pas suffisamment différentes, le transistor 36 qui est passant permet d'assurer un chemin de conduction entre les noeuds A et D jusqu'à ce que le signal G soit de façon certaine à "0".

A l'instant t₂, le signal Rst passe de "0" à "1". Le transistor 36 passe à l'état bloqué.

A l'instant t₃, la tension appliquée sur la cellule mémoire Cell_{i,j} est suffisamment élevée pour entraîner la commutation de la cellule mémoire. La résistance de l'élément résistif de la cellule mémoire Cell_{i,j} passe de Ron à Roff. La tension Vrm s'élève alors au-dessus de Vref. Le courant I diminue.

A l'instant t₄, le signal G fourni par le comparateur 40 passe à "1". Le transistor 38 passe à l'état bloqué. Le courant I s'annule et aucune tension n'est plus appliquée à la cellule mémoire Cell_{i,j}.

A l'instant t₅, le circuit 30 interrompt la fourniture de la tension VRamp, par exemple après une durée déterminée.

A titre de variante, le transistor 36 peut ne pas être présent. Le dispositif d'effacement 14 peut alors comprendre des moyens pour assurer que le signal G est à "0" au début d'une opération d'effacement. A titre d'exemple, le dispositif d'effacement 14 peut comprendre un élément de mémorisation du type bascule (en anglais flip-flop) entre le comparateur 40 et le transistor 38.

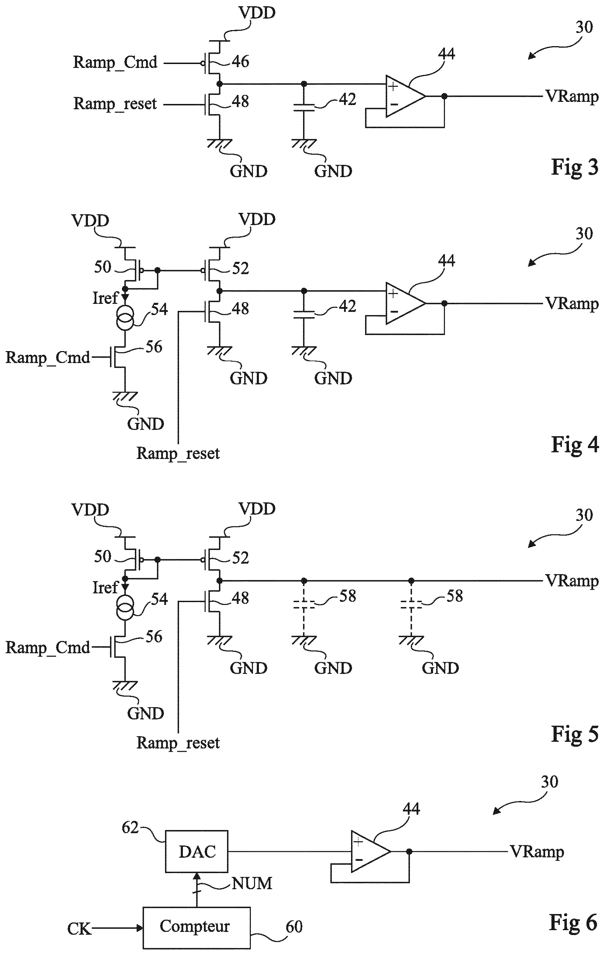

La figure 3 représente un mode de réalisation du circuit 30 de fourniture de la tension VRamp. Dans ce mode de réalisation, le circuit 30 comprend un condensateur 42 dont une électrode est reliée à la masse GND et dont l'autre électrode est reliée à l'entrée non inverseuse (+) d'un amplificateur opérationnel 44 monté en suiveur. L'entrée inverseuse (-) de l'amplificateur opérationnel 44 est reliée à la sortie de l'amplificateur opérationnel 44. L''amplificateur opérationnel 44 fournit la tension VRamp. Le circuit 30 comprend, en outre, un transistor MOS 46 à canal P et un transistor MOS 48 à canal N. La source du transistor 46 est reliée à une source d'un potentiel haut VDD. Les drains des transistors 46 et 48 sont reliés à l'entrée non inverseuse (+) de l'amplificateur opérationnel 44. La source du transistor 48 est reliée à la masse GND. La grille du transistor MOS reçoit un signal binaire Ramp_Cmd et la grille du transistor 48 reçoit un signal binaire Ramp_reset.

Le fonctionnement du circuit 30 représenté en figure 3 est le suivant. Le condensateur 42 est déchargé en rendant passant le transistor 48, le transistor 46 étant bloqué. Le transistor 48 est ensuite rendu passant et le transistor 46 est bloqué. Les propriétés de conduction du transistor 46 sont choisies pour que la charge du condensateur 42 soit progressive. La tension aux bornes du condensateur 42 correspond à la tension VRamp. L'amplificateur opérationnel 44 recopie la tension Vramp.

La figure 4 représente un autre mode de réalisation du circuit 30 de fourniture de la tension VRamp. Dans ce mode de réalisation, au lieu du transistor 46, il est prévu un miroir de courant comprenant deux transistors MOS 50 et 52 à canal P, une source de courant 54 fournissant un courant Iref et un transistor MOS 56 à canal N. Les sources des transistors 50 et 52 sont reliées à la source du potentiel VDD. Le drain du transistor 52 est relié à l'entrée non inverseuse (+) de l'amplificateur opérationnel 44. La grille du transistor 50 est reliée à la grille du transistor 52, au drain du transistor 50 et à une borne de la source de courant 54. L'autre borne de la source de courant 54 est reliée au drain du transistor 56 et la source du transistor 56 est reliée à la masse GND.

Le miroir de courant recopie le courant Iref fourni par la source de courant 54 avec un facteur multiplicatif égal au rapport entre les largeurs de grille des transistors 52 et 50. Lorsque le transistor 56 est passant et que le transistor 48 est bloqué, le condensateur 42 est chargé à courant constant avec le courant recopié par le miroir de courant. Le mode de réalisation représenté en figure 4 permet d'obtenir une rampe plus linéaire et de mieux contrôler la durée de la rampe par rapport au mode de réalisation représenté en figure 3.

La figure 5 représente un autre mode de réalisation du circuit 30 de fourniture de la tension VRamp. Par rapport au mode de réalisation représenté en figure 4, le condensateur 42 et l'amplificateur opérationnel 44 ne sont pas présents. Le rôle joué par le condensateur 42 est rempli dans le présent mode de réalisation par la capacité parasite, illustrée en figure 5 par des condensateurs 58 représentés par des tirets, de la piste conductrice qui transmet la tension VRamp.

La figure 6 représente un autre mode de réalisation du circuit 30 de fourniture de la tension VRamp. Dans ce mode de réalisation, le circuit 30 comprend un compteur 60 (Compteur) cadencé par un signal d'horloge CK et fournissant un signal numérique NUM codé sur plusieurs bits. Le signal NUM est reçu par un convertisseur numérique-analogique 62 (DAC) qui convertit le signal numérique NUM en un signal analogique fourni à l'entrée non inverseuse (+) de l'amplificateur opérationnel 44. La vitesse de croissance du signal VRamp est déterminée par la fréquence du signal d'horloge CK et le nombre de bits du signal NUM. A titre de variante, un filtre passe-bas peut être interposé entre le convertisseur numérique-analogique 62 et l'amplificateur opérationnel 44 pour lisser la tension VRamp. En pratique, la fonction de filtre passe-bas peut être réalisée par l'amplificateur opérationnel 44 et la capacité parasite de la piste conductrice transmettant la tension VRamp.

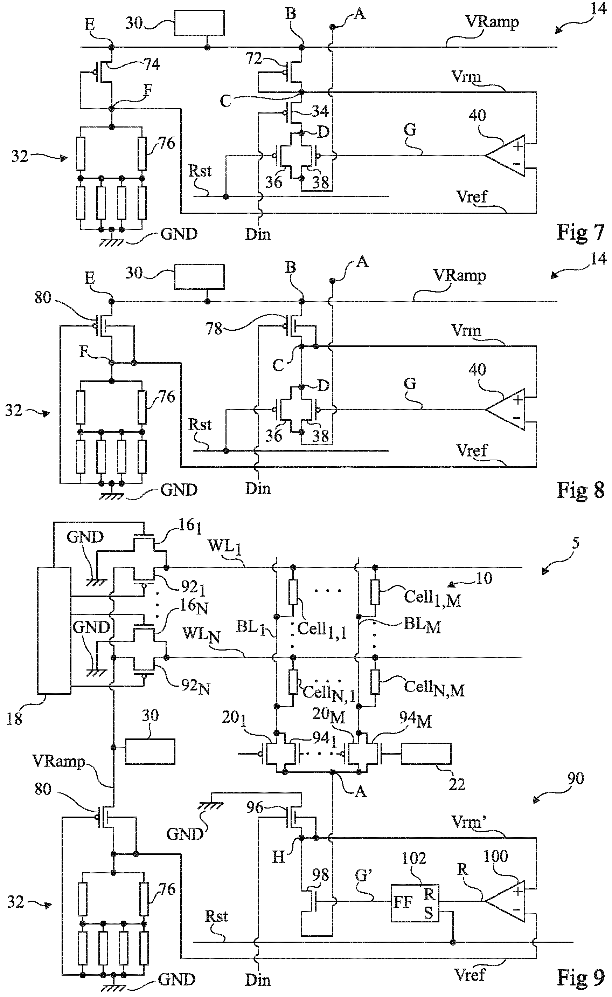

La figure 7 représente un mode de réalisation plus détaillé du dispositif d'effacement 14 dans lequel la résistance Rm est réalisée par un transistor MOS 72 à canal P monté en diode. La source du transistor 72 est reliée au noeud B, le drain et la grille du transistor 72 étant reliés au noeud C.

Le circuit 32 de fourniture de la tension VRamp comprend un transistor MOS 74 à canal P, monté en diode, entre un noeud E et un noeud F. Le noeud E reçoit la tension VRamp. La source du transistor 74 est reliée au noeud E, le drain et la grille du transistor 74 étant reliés au noeud F. De préférence, le transistor 74 est identique au transistor 72. Lorsque la résistance Rm est formée par une piste de silicium polycristallin, le transistor MOS 74 est de préférence remplacé par une résistance identique en silicium polycristallin.

Le circuit 32 comprend, en outre, entre le noeud F et la masse GND, un ensemble de cellules mémoires 76 montées en série et en parallèle de façon que la résistance équivalente Req de l'ensemble des cellules mémoires 76 est inférieure strictement à Roff. A titre d'exemple, un ensemble de six cellules mémoires 72 ayant chacune une résistance Roff est représenté en figure 7 et les cellules mémoires de cet ensemble sont agencées de façon que la résistance équivalente Req de l'ensemble des cellules mémoires 76 est égale à 3/4*Roff. A titre de variante, des cellules mémoires 76 ayant chacune une résistance Ron peuvent être utilisées. Le circuit 32 peut, en outre, comprendre en série avec l'ensemble de cellules mémoires 76 une résistance représentative des résistances parasites sur la ligne de bits BLⱼ et la ligne de mots WLᵢ lors de la sélection de la cellule mémoire Cell_{i,j}. Comme les cellules mémoires 76 sont en série, chaque cellule mémoire 76 ne voit pas une tension suffisamment élevée pour commuter. Le circuit 32 joue le rôle d'un diviseur de tension. La tension Vref est donnée par la relation (2) suivante : $Vref = \frac{Req}{Req + Rm} VRamp$ (2)

La figure 8 représente un autre mode de réalisation plus détaillé du dispositif d'effacement 14 dans lequel la résistance Rm et le transistor 34 représentés en figure 1 sont remplacés par un transistor MOS 78 à canal P dont la source est reliée au noeud B, dont le drain est relié au noeud D, dont la grille reçoit le signal Din et dont le substrat est relié au drain. Ceci signifie que, dans le cas où le substrat du transistor 78 correspond à une région dopée de type N dans laquelle sont formées des régions dopées de type P correspondant au drain et à la source du transistor 78, le drain et le substrat sont amenés sensiblement au même potentiel.

Le mode de réalisation représenté en figure 8 permet, de façon avantageuse, de supprimer l'un des transistors MOS 72 et 34 par rapport au mode de réalisation représenté en figure 7. Comme le substrat et le drain du transistor 78 sont reliés ensemble, la tension de seuil du transistor 78 est d'autant plus faible que la tension Vrm est basse. De ce fait, on évite de perdre la tension de seuil du transistor 72 monté en diode dans la tension VRamp. Une tension VRamp moins élevée peut ainsi être utilisée, ce qui permet de réduire la consommation électrique du dispositif d'effacement 14.

De préférence, le circuit 32 de fourniture de la tension Vref, représenté en figure 8, comprend, à la place du transistor 74 représenté en figure 7, un transistor MOS 80 à canal P identique au transistor 78, dont la source est reliée au noeud E, dont le drain est relié au noeud F, dont la grille est reliée à la masse GND et dont le substrat est relié au drain.

La figure 9 représente un mode de réalisation de la mémoire 5 dans lequel la mémoire 5 comprend un dispositif 90 d'écriture des cellules mémoires Cell_{i,j}, c'est-à-dire adapté à faire passer la résistance de l'élément résistif d'une cellule mémoire Cell_{i,j} de Roff à Ron. Les éléments communs avec le dispositif d'effacement 14 représenté en figure 1 sont désignés par les mêmes références.

Chaque ligne de mot WLᵢ, i variant de 1 à N, est reliée au circuit 30 de fourniture de la tension VRamp par l'intermédiaire d'un interrupteur 92ᵢ. Les interrupteurs 92ᵢ sont commandés par le module 18 de sélection de lignes de mots. A titre d'exemple, chaque interrupteur 92 correspond à un transistor MOS à canal P dont le drain est relié à la ligne de mots WLᵢ, dont la source est reliée au circuit 30 et dont la grille est commandée par le module 18. Chaque ligne de bits BLⱼ, j variant de 1 à M, est reliée au noeud A par l'intermédiaire d'un interrupteur 94ⱼ. Les interrupteurs 94 sont commandés par le module 22 de sélection de lignes de bits. A titre d'exemple, chaque interrupteur 94ⱼ correspond à un transistor MOS à canal N dont le drain est relié à la ligne de bits BLⱼ, dont la source est reliée au noeud A et dont la grille est commandée par le module 22.

Le dispositif d'écriture 90 comprend un transistor MOS 96 à canal N dont la source est reliée à la masse GND, dont le drain est relié à un noeud H, dont la grille reçoit le signal Din et dont le substrat est relié au drain. On appelle Rm' la résistance équivalente du transistor 96. On appelle Vrm' la tension entre le noeud H et la masse GND. Un interrupteur 98 est monté entre les noeuds H et A. L'interrupteur 98 est commandé par un signal binaire G'. A titre d'exemple, l'interrupteur 98 correspond à un transistor MOS à canal N, dont la source est reliée au noeud H, dont le drain est relié au noeud A et dont la grille est commandée par le signal G'.

Le dispositif d'écriture 90 comprend, en outre, un amplificateur opérationnel 100, monté en comparateur, dont l'entrée non inverseuse (+) est reliée au noeud H et reçoit la tension Vrm' et dont l'entrée inverseuse (-) est reliée au circuit 32 et reçoit la tension Vref. Le comparateur 100 fournit un signal binaire R. A titre d'exemple, le signal R est à "0" lorsque la tension Vrm' est inférieure strictement à la tension Vref et est à "1" lorsque la tension Vrm' est supérieure strictement à la tension Vref.

Le dispositif d'écriture 90 comprend, en outre, un élément de mémorisation 102 de type bascule, qui fournit le signal G'. La bascule 102 comprend une entrée de commande S recevant le signal binaire Rst et une entrée R de remise à zéro recevant le signal R. De façon classique, lorsque le signal Rst sur l'entrée de commande S passe de "0" à "1", la sortie G' de la bascule 102 est mise à "1". Lorsque le signal R sur l'entrée R de mise à zéro passe de "0" à "1", la sortie G' de la bascule 102 passe à "0". Lorsque le signal R sur l'entrée R de mise à zéro passe de "1" à "0" ou lorsque le signal Rst sur l'entrée S de commande passe de "1" à "0", la sortie G' de la bascule 102 n'est pas modifiée.

Lorsqu'une cellule mémoire Cell_{i,j} est sélectionnée pour une opération d'écriture, la cellule mémoire Cell_{i,j} et la résistance Rm' équivalente du transistor MOS 96 forment un pont diviseur de tension. La tension Vrm' est donnée par la relation (3) suivante : $Vrm ′ = \frac{Rm ′}{RCell + Rm ′} VRamp$ (3)

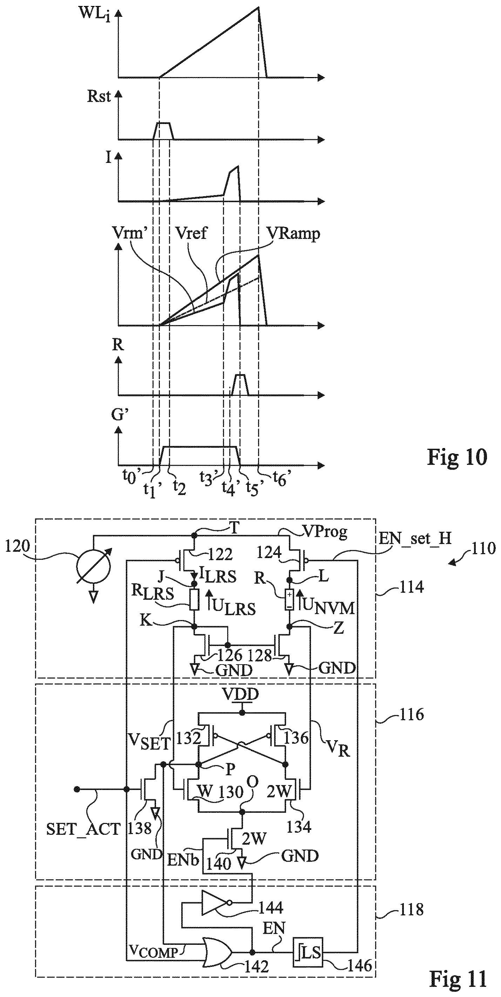

La figure 10 représente des chronogrammes de signaux mis en oeuvre par la mémoire 5 de la figure 9 lors d'une opération d'écriture. Les instants t'₀ à t'₆ sont des instants successifs.

A l'instant t'₀, le signal Rst passe à "1", ce qui entraîne la mise à "1" du signal G' en sortie de la bascule 102. Le transistor 98 devient donc passant. Le signal Din est à "1" lorsqu'une opération d'écriture doit être réalisée dans la cellule mémoire sélectionnée. Le transistor 96 est alors passant.

A l'instant t'₁, la tension VRamp commence à croître depuis la valeur nulle. Les tensions Vref et Vrm' commencent donc à croître. En outre, un courant I commence à circuler dans la cellule mémoire Cell_{i,j} sélectionnée. La résistance de la cellule mémoire Cell_{i,j} étant égale à Roff, la tension Vrm' est inférieure strictement à la tension Vref. Le signal R fourni par le comparateur 100 est à "0". Toutefois, la sortie G' de la bascule reste à "1".

A l'instant t'₂, le signal Rst passe de "1" à "0". Le signal G' en sortie de la bascule 102 n'est toutefois pas modifié.

A l'instant t'₃, la tension appliquée sur la cellule mémoire Cell_{i,j} est suffisamment élevée pour entraîner la commutation de la cellule mémoire. La résistance de l'élément résistif de la cellule mémoire Cell_{i,j} passe de Roff à Ron. La tension Vrm' s'élève alors au-dessus de Vref. Le courant I diminue et le signal R fourni par le comparateur 100 passe à "1".

A l'instant t'₅, la bascule 102 recevant le signal R met le signal G' à "0". L'interrupteur 98 passe à l'état bloqué. Le courant I s'annule et aucune tension n'est plus appliquée à la cellule mémoire Cell_{i,j}. Au cours de sa chute, la tension Vrm' passe au-dessous de la tension Vref et le signal R' passe à "0". Toutefois, le signal G' est maintenu à "0".

A l'instant t'₆, le circuit 30 interrompt la fourniture de la tension VRamp.

Dans le mode de réalisation représenté en figure 9, pour réaliser une opération d'écriture, la ligne de bits BLⱼ reliée à la cellule mémoire Cell_{i,j} sélectionnée est mise à la masse GND et la ligne de mots WLᵢ reliée à la cellule mémoire Cell_{i,j} sélectionnée reçoit la tension VRamp. Ceci permet avantageusement d'utiliser le même circuit 30 pour une opération d'écriture et une opération d'effacement. Selon un autre mode de réalisation, pour réaliser une opération d'effacement, la ligne de mots WLᵢ reliée à la cellule mémoire Cell_{i,j} sélectionnée peut être mise au potentiel haut VDD et la ligne de bits BLⱼ reliée à la cellule mémoire Cell_{i,j} sélectionnée peut recevoir une tension continument décroissante, par exemple de VDD à 0 V.

Selon un mode de réalisation, la mémoire 5 peut comprendre le dispositif d'effacement 14 représenté en figure 1 et le dispositif d'écriture 90 représenté en figure 9. Dans ce cas, les circuits 30 et 32 peuvent être communs aux dispositifs d'écriture et d'effacement. En outre, dans le cas où le dispositif d'effacement 14 comprend également une bascule, la bascule 102 et l'amplificateur opérationnel 100 peuvent être communs au dispositif d'effacement 14 et au dispositif d'écriture 90.

Selon un autre mode de réalisation, une opération d'écriture dans une cellule mémoire d'une mémoire résistive et/ou d'effacement de la cellule mémoire est réalisée de la façon suivante :
- circulation d'un courant dans la cellule mémoire ;
- comparaison de la tension aux bornes de la cellule mémoire avec une tension de référence ;
- détection de la commutation de la cellule mémoire à partir de la comparaison de la tension aux bornes de la cellule mémoire et de la tension de référence ; et
- coupure automatique du courant traversant la cellule mémoire après la détection.

Pour chaque cellule mémoire, la consommation de la cellule mémoire est réduite puisque le courant alimentant chaque cellule mémoire est interrompu dès que la cellule mémoire a commuté. La durée de vie de la cellule mémoire est de façon avantageuse préservée puisque la cellule mémoire n'est pas soumise à la tension de commutation plus longtemps que nécessaire. En outre, le courant traversant la cellule mémoire est interrompu lorsque la tension aux bornes de la cellule mémoire atteint une tension déterminée, c'est-à-dire lorsque la résistance de la cellule mémoire atteint une résistance déterminée. De façon avantageuse, les résistances Ron des cellules mémoires après une opération d'écriture sont sensiblement égales et les résistances Roff des cellules mémoires après une opération d'effacement sont sensiblement égales.

Le principe de fonctionnement d'un dispositif d'écriture et d'un dispositif d'effacement va dans un premier temps être décrit pour une opération d'écriture ou d'effacement pour une seule cellule mémoire. L'utilisation du dispositif d'écriture et du dispositif d'effacement avec une mémoire résistive comprenant plusieurs cellules mémoires est décrite dans un second temps.

La figure 11 représente un autre mode de réalisation d'un dispositif d'écriture 110 d'un élément résistif R d'une cellule mémoire. Le dispositif d'écriture 110 comprend un circuit de programmation 114, un circuit de détection de fin d'écriture 116 et un circuit logique de contre réaction 118.

Le circuit de programmation 114 comprend un circuit 120 de fourniture d'une tension de programmation VProg à un noeud T. La tension VProg peut être une tension constante ou une tension monotone par palier, par exemple continument croissante, par exemple une rampe de tension, pendant une partie d'une opération d'écriture ou d'effacement, par exemple du début d'une opération d'écriture ou d'effacement au moins jusqu'à la commutation de la cellule mémoire, puis décroissante à la fin de l'opération d'écriture ou d'effacement. Le circuit 120 peut avoir la même structure que le circuit 30 décrit précédemment. Le circuit de programmation 114 comprend, en outre, une résistance de référence R_{LRS} entre des noeuds J et K et un interrupteur 122 commandé par un signal binaire SET_ACT entre le noeud T et le noeud J. L'interrupteur 122 peut correspondre à un transistor MOS à canal P dont la source est reliée au noeud T, dont le drain est relié au noeud J et dont la grille reçoit le signal SET_ACT. Selon un mode de réalisation, la résistance de référence R_{LRS} est sensiblement égale au niveau de résistance Ron souhaitée pour l'élément résistif R. La résistance R_{LRS} peut être réalisée par une piste de silicium polycristallin.

L'élément résistif R est placé entre des noeuds L et Z. Le circuit de programmation 114 comprend un interrupteur 124 commandé par un signal binaire EN_set_H entre le noeud T et le noeud L. L'interrupteur 124 peut correspondre à un transistor MOS à canal P dont la source est reliée au noeud T, dont le drain est relié au noeud L et dont la grille reçoit le signal EN_set_H.

Le circuit de programmation 114 comprend un miroir de courant qui reproduit le courant traversant la résistance R_{LRS} dans l'élément résistif R. Le miroir de courant comprend, par exemple, un transistor MOS 126 à canal N, monté en diode, dont le drain est relié au noeud K, dont la source est reliée à la masse GND et dont la grille est reliée au drain. Le miroir de courant comprend, en outre, un transistor MOS 128 à canal N, dont le drain est relié au noeud Z, dont la source est reliée à la masse GND et dont la grille est reliée à la grille du transistor 126. On appelle V_{SET} la tension entre le noeud K et la masse GND et V_{R} la tension entre le noeud Z et la masse GND.

Le circuit de détection 116 est adapté à comparer les tensions V_{SET} et V_{R}. Il comprend un transistor MOS 130 à canal N dont la source est reliée à un noeud O, dont le drain est relié à un noeud P et dont la grille est reliée au noeud K et reçoit la tension V_{SET}. On appelle V_{COMP} la tension entre le noeud P et la masse GND. Le noeud P est relié au drain d'un transistor MOS 132 à canal P. Le circuit de détection 116 comprend, en outre, un transistor MOS 134 à canal N dont la source est reliée au noeud O, dont le drain est relié au drain d'un transistor MOS 136 à canal P et dont la grille est reliée au noeud Z et reçoit la tension V_{R}. Les sources des transistors MOS 132 et 136 sont reliées à une source du potentiel de référence haut VDD. La grille du transistor 132 est reliée au drain du transistor 136 et la grille du transistor 136 est reliée au drain du transistor 132. De préférence, la largeur de grille du transistor 134 est supérieure à la largeur de grille du transistor 130. A titre d'exemple, la largeur de grille du transistor 134 est égale au double de la largeur de grille du transistor 130.

Le circuit de détection 116 comprend, entre le noeud P et la masse GND, un interrupteur 138 commandé par le signal binaire SET_ACT. L'interrupteur 138 peut correspondre à un transistor MOS à canal N dont la source est reliée à la masse GND, dont le drain est relié au noeud P et dont la grille reçoit le signal SET_ACT. Le circuit de détection 116 comprend, en outre, entre le noeud O et la masse GND, un interrupteur 140 commandé par un signal binaire ENb. L'interrupteur 140 peut correspondre à un transistor MOS à canal N dont la source est reliée à la masse GND, dont le drain est relié au noeud O et dont la grille reçoit le signal ENb. La largeur de grille du transistor 140 peut être égale à la somme de la largeur de grille du transistor 134 et de la largeur de grille du transistor 130.

Le circuit logique 118 comprend un bloc 142 réalisant la fonction logique "OU", recevant les signaux V_{COMP} et SET_ACT et fournissant un signal binaire EN. Le circuit logique 118 comprend, en outre, un bloc 144 réalisant la fonction logique "NON", recevant le signal EN et fournissant le signal ENb. Le circuit logique 118 peut, en outre, comprendre un circuit de conversion de niveau 146 recevant le signal EN et fournissant le signal EN_set_H. L'état haut du signal EN_set_H est à une tension supérieure à l'état haut du signal EN et est adapté à la commande de certains transistors MOS. A titre d'exemple, l'état haut du signal EN_set_H correspond à VProg. A titre de variante, le circuit 146 peut ne pas être présent.

Selon un mode de réalisation, le dispositif 110 peut comprendre, en outre, un convertisseur de tension recevant le signal SET_ACT et dont la sortie est reliée à la grille du transistor 138 et à la grille du transistor 122.

Le fonctionnement du dispositif d'écriture 110 est le suivant. Avant le début d'une opération d'écriture, le signal SET_ACT est à "1". Le transistor 138 est donc passant, ce qui maintient la tension V_{COMP} à "0". En outre, le transistor 122 est bloqué. Aucun courant ne circule dans la résistance R_{LRS}. Le signal EN est à "1" et le signal ENb est à "0". Le transistor 140 est donc bloqué. Le signal EN_set_H est à "1". Le transistor 124 est donc bloqué. Aucun courant ne circule dans l'élément résistif R.

Au début d'une opération d'écriture, le signal SET_ACT est mis à "0". Le transistor 122 devient donc passant. Comme le signal V_{COMP} est à "0", le signal EN passe à "0" et le signal ENb passe à "1". Le transistor 140 devient donc passant. Le signal EN_set_H passe à "0". Le transistor 124 devient donc passant. Le circuit 120 fournissant la tension de programmation VProg conduit à la circulation d'un courant I_{LRS} dans la résistance R_{LRS}. Le courant I_{LRS} est recopié par le miroir de courant et circule dans l'élément résistif R. La résistance de l'élément résistif R pouvant être supposée égale à Roff, c'est-à-dire supérieure à R_{LRS}, la tension U_{NVM} aux bornes de l'élément résistif R est supérieure à la tension U_{LRS} aux bornes de la résistance R_{LRS}. Comme les tensions drain-source des transistors 122 et 124 sont identiques et sensiblement nulles, la tension V_{R} est inférieure à la tension V_{SET}. Le transistor 130 est donc davantage passant que le transistor 134. Le signal V_{COMP} reste à "0", le transistor 136 étant passant et le transistor 132 étant bloqué.

Lorsque l'élément résistif R commute, la résistance de l'élément résistif R diminue. Lorsque la résistance de l'élément résistif R devient sensiblement égale à R_{LRS}, la tension U_{NVM} devient sensiblement égale à la tension U_{LRS} et la tension V_{R} devient sensiblement égale à V_{SET}. Comme la largeur de grille du transistor 134 est supérieure à la largeur de grille du transistor 130, le transistor 134 est davantage passant que le transistor 130. Ceci entraîne un basculement de V_{COMP} de "0" à "1", le transistor 132 devenant passant et le transistor 136 devenant bloqué. Le signal EN, et donc le signal EN_set_H, passent alors de "0" à "1". Le transistor 124 est bloqué, interrompant la circulation de courant dans l'élément résistif R. En outre, le signal ENb passe de "1" à "0" entraînant le blocage du transistor 140.

Selon un autre mode de réalisation, la largeur de grille du transistor 134 peut ne pas être supérieure à la largeur de grille du transistor 130. Dans ce cas, la résistance de référence R_{LRS} est supérieure à la résistance Ron souhaitée. Lorsque l'élément résistif R commute, la résistance de l'élément résistif R diminue depuis Roff vers Ron. Lorsque la résistance de l'élément résistif R devient inférieure à la résistance R_{LRS}, la tension U_{NVM} devient inférieure à la tension U_{LRS} et la tension V_{R} devient supérieure à V_{SET}. Le transistor 134 est davantage passant que le transistor 130. Ceci entraîne un basculement de V_{COMP} de "0" à "1".

Pour chaque cellule mémoire, le courant traversant la cellule mémoire est interrompu dès que la cellule mémoire a commuté. La durée de vie de la cellule mémoire est de façon avantageuse préservée puisque la cellule mémoire n'est pas soumise, plus longtemps que nécessaire, à la tension et au courant permettant sa commutation. En outre, la consommation de la cellule mémoire lors d'une opération d'écriture est réduite. En outre, dans le présent mode de réalisation, la circulation de courant dans l'élément résistif R est interrompue après que la résistance de l'élément résistif R atteint une valeur déterminée pour laquelle le signal V_{COMP} passe de "0" à "1". On commande ainsi la résistance de l'élément résistif R après la commutation.

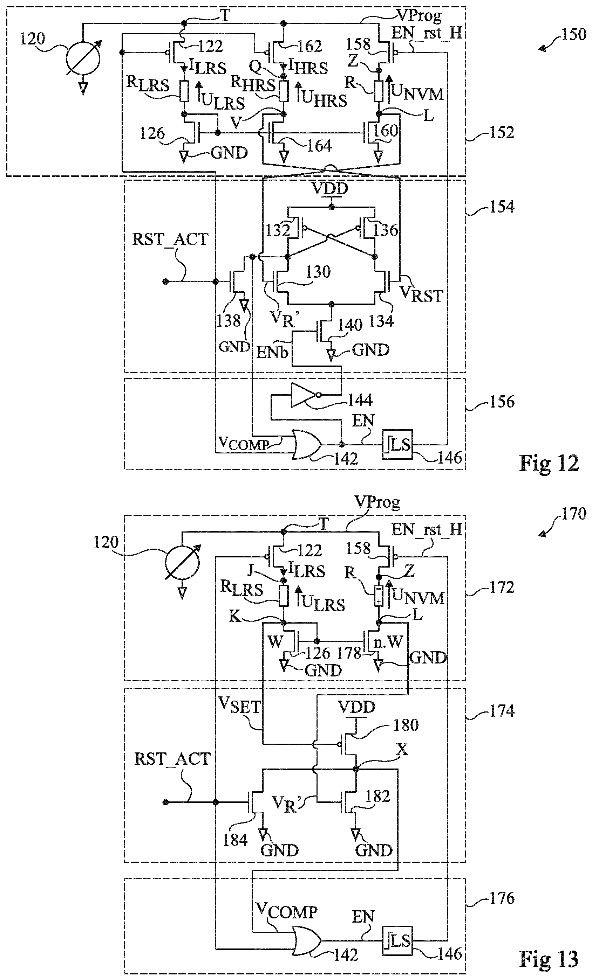

La figure 12 représente un mode de réalisation d'un dispositif d'effacement 150 d'un élément résistif R.

Le dispositif d'effacement 150 comprend un circuit de programmation 152, un circuit de détection de fin d'effacement 154 et un circuit logique de contre réaction 156. Le circuit de détection 154 peut être identique au circuit 116 décrit précédemment à la différence que le signal SET_ACT est remplacé par un signal binaire RST_ACT. Le circuit logique 156 peut être identique au circuit logique 118 décrit précédemment à la différence que le signal SET_ACT est remplacé par un signal binaire RST_ACT et que le signal EN_set_H est remplacé par un signal binaire EN_rst_H.

Le circuit de programmation 152 comprend certains éléments du circuit de programmation 114 décrit précédemment. Le circuit de programmation 152 comprend notamment le circuit 120 de fourniture de la tension VProg au noeud T. Le circuit de programmation 152 comprend un interrupteur 158 commandé par le signal binaire EN_rst_H entre le noeud T et le noeud Z. L'interrupteur 158 peut correspondre à un transistor MOS à canal P dont la source est reliée au noeud T, dont le drain est relié au noeud Z et dont la grille reçoit le signal EN_rst_H.

Le circuit de programmation 152 comprend un transistor MOS 160 à canal N, dont le drain est relié au noeud L, dont la source est reliée à la masse GND et dont la grille est reliée à la grille du transistor MOS 126. On appelle V_{R}' la tension entre le noeud L et la masse GND.

Le circuit de programmation 152 comprend, en outre, une résistance de référence R_{HRS} entre des noeuds Q et V et un interrupteur 162 commandé par le signal binaire RST_ACT entre le noeud T et le noeud Q. L'interrupteur 162 peut correspondre à un transistor MOS à canal P dont la source est reliée au noeud T, dont le drain est relié au noeud Q et dont la grille reçoit le signal RST_ACT. Dans le présent mode de réalisation, la résistance R_{HRS} est sensiblement égale à la résistance Roff souhaitée pour l'élément résistif R. La résistance R_{HRS} peut être réalisée par une piste de silicium polycristallin. On appelle U_{HRS} la tension aux bornes de la résistance R_{HRS} et V_{RST} la tension entre le noeud V et la masse GND. Le circuit de programmation 152 comprend, en outre, un transistor MOS 164 à canal N dont le drain est relié au noeud V, dont la source est reliée à la masse GND et dont la grille est reliée à la grille du transistor 126. Le noeud V est relié à la grille du transistor 134 et le noeud L est relié à grille du transistor 130.

La largeur de grille du transistor 160 peut être supérieure à la largeur de grille du transistor 126.

Le fonctionnement du dispositif d'effacement 150 est le suivant. Avant le début d'une opération d'effacement, le signal RST_ACT est à "1". Le transistor 138 est donc passant, ce qui maintient le signal V_{COMP} à "0". En outre, les transistors 122 et 162 sont bloqués. Aucun courant ne circule dans les résistances R_{LRS} et R_{HRS}. Le signal EN est à "1" et le signal ENb est à "0". Le transistor 140 est donc bloqué. Le signal EN_rst_H est à "1". Le transistor 158 est donc bloqué. Aucun courant ne circule dans l'élément résistif R.

Au début d'une opération d'effacement, le signal RST_ACT est mis à "0". Les transistors 122 et 162 deviennent donc passants. Comme le signal V_{COMP} est à "0", le signal EN passe à "0" et le signal ENb passe à "1". Le transistor 140 devient donc passant. Le signal EN_rst_H passe à "0". Le transistor 158 devient donc passant. Le circuit 120 fournit la tension de programmation VProg. Celle-ci conduit à la circulation d'un courant I_{LRS} dans la résistance R_{LRS}. Le courant I_{LRS}, recopié par le miroir de courant, éventuellement avec un facteur de multiplication supérieur à 1, circule dans l'élément résistif R et dans la résistance R_{HRS}. La résistance de l'élément résistif R étant de niveau bas, la tension U_{NVM} aux bornes de l'élément résistif R est inférieure à la tension U_{HRS} aux bornes de la résistance R_{HRS} et la tension V_{R}' est supérieure à la tension V_{RST}. Le transistor 130 est donc davantage passant que le transistor 134. Le signal V_{COMP} reste donc à "0", le transistor 136 étant passant et le transistor 132 étant bloqué.

Lorsque l'élément résistif R commute, la résistance de l'élément résistif R augmente. Lorsque la tension U_{NVM} devient sensiblement égale à la tension U_{HRS}, la tension V_{R}' devient sensiblement égale à V_{RST}. Comme la largeur de grille du transistor 134 est supérieure à la largeur de grille du transistor 130, le transistor 134 est davantage passant que le transistor 130. Ceci entraîne un basculement de V_{COMP} de l'état "0" à l'état "1", le transistor 132 devenant passant et le transistor 136 devenant bloqué. Le signal EN et le signal EN_rst_H passent alors de "0" à "1". Le transistor 158 est alors bloqué, interrompant la circulation de courant dans l'élément résistif R. En outre, le signal ENb passe de "1" à "0" entraînant le blocage du transistor 140.

Selon un autre mode de réalisation, la largeur de grille du transistor 134 peut ne pas être supérieure à la largeur de grille du transistor 130. Dans ce cas, la résistance de référence R_{HRS} est inférieure à la résistance Roff souhaitée. Lorsque l'élément résistif R commute, la résistance de l'élément résistif R augmente de Ron vers Roff. Lorsque la résistance de l'élément résistif R devient supérieure à la résistance R_{HRS}, la tension U_{NVM} devient supérieure à la tension U_{HRS} et la tension V_{R}' devient inférieur à V_{RST}. Le transistor 134 est davantage passant que le transistor 130. Ceci entraîne un basculement de V_{COMP} de **"0"** à **"1".**

Pour chaque cellule mémoire, le courant traversant la cellule mémoire est interrompu dès que la cellule mémoire a commuté. La durée de vie de la cellule mémoire est de façon avantageuse préservée puisque la cellule mémoire n'est pas soumise, plus longtemps que nécessaire, à la tension et au courant permettant sa commutation. En outre, la consommation de la cellule mémoire lors d'une opération d'effacement est réduite. En outre, dans le présent mode de réalisation, la circulation de courant dans l'élément résistif R est interrompue après que la résistance de l'élément résistif R atteint une valeur déterminée pour laquelle le signal V_{COMP} passe de "0" à "1". On commande ainsi la résistance de l'élément résistif R après la commutation.

La figure 13 représente un autre mode de réalisation d'un dispositif d'effacement 170 d'un élément résistif R.

Le dispositif d'effacement 170 comprend un circuit de programmation 172, un circuit de détection de fin d'effacement 174 et un circuit logique de contre réaction 176. Le circuit de programmation 172 comprend les transistors 122 et 126 et la résistance R_{LRS} du circuit 114 décrit précédemment en relation avec la figure 11. Le circuit de programmation 172 comprend, en outre, le transistor 158 du circuit 152 décrit précédemment en relation avec la figure 12. L'élément résistif R est connecté comme pour le circuit 152. Le circuit de programmation 172 comprend, en outre, un transistor MOS 178 à canal N dont la source est reliée à la masse GND, dont la grille est reliée à la grille du transistor 126 et dont le drain est relié au noeud L. La largeur de grille du transistor 178 peut être supérieure, par exemple d'un facteur n supérieur à 1, à la largeur de grille du transistor 126. Le circuit logique 176 peut comprendre le bloc logique 142 et le circuit de mise à niveau 146 du circuit logique 156 décrits précédemment.

Le circuit de détection 174 comprend un transistor MOS 180 à canal P dont la source est reliée à la source du potentiel de référence VDD, dont la grille est reliée au noeud K et reçoit la tension V_{SET} et dont le drain est relié à un noeud X. Le circuit de détection 174 comprend un transistor MOS 182 à canal N dont la source est reliée à la masse GND, dont la grille est reliée au noeud L et reçoit la tension V_{R}' et dont le drain et relié au noeud X. Le noeud X fournit le signal V_{COMP} reçu par la porte logique "OU" 142. Le circuit de détection 174 comprend un transistor MOS 184 à canal N dont la source est reliée à la masse GND, dont la grille reçoit le signal RST_ACT et dont le drain est relié au noeud X.

Le fonctionnement du dispositif d'effacement 170 est le suivant. Avant le début d'une opération d'effacement, le signal RST_ACT est à "1". Le transistor 122 est donc bloqué. Aucun courant ne circule dans la résistance R_{LRS}. Le transistor 184 est passant et le signal V_{COMP} est à "0". Le signal EN est à "1" et le signal EN_rst_H est à "1". Le transistor 158 est donc bloqué. Aucun courant ne circule dans l'élément résistif R.

Au début d'une opération d'effacement, le signal RST_ACT est mis à "0". Le transistor 122 devient donc passant et le transistor 184 est bloqué. Comme le signal V_{COMP} est à "0", le signal EN et le signal EN_rst_H passent à "0". Le transistor 158 devient donc passant. Le circuit 120 fournit la tension de programmation VProg. Celle-ci conduit à la circulation d'un courant I_{LRS} dans la résistance R_{LRS}. Le courant I_{LRS} est recopié par le miroir de courant et circule dans l'élément résistif R multiplié par le facteur de multiplication n. La résistance de l'élément résistif R étant initialement de valeur Ron, la tension U_{NVM} aux bornes de l'élément résistif R est de l'ordre de n fois la tension U_{LRS} aux bornes de la résistance R_{LRS}. Les transistors 180 et 182 sont dimensionnés pour que dans cette configuration, le transistor 182 soit davantage passant que le transistor 180. Le signal V_{COMP} reste donc à "0".

Lorsque l'élément résistif R commute, la résistance de l'élément résistif R augmente de Ron à Roff. La tension U_{NVM} augmente et le signal V_{R}' diminue. Le transistor 180 devient alors davantage passant que le transistor 182. Ceci entraîne un basculement de V_{COMP} de "0" à "1". Le signal EN et le signal EN_rst_H passent de "0" à "1". Le transistor 158 est alors bloqué, interrompant la circulation de courant dans l'élément résistif R et donc l'opération d'effacement.

Pour chaque cellule mémoire, le courant traversant la cellule mémoire est interrompu peu après que la cellule mémoire a commuté. La durée de vie de la cellule mémoire est de façon avantageuse préservée puisque la cellule mémoire n'est pas soumise, plus longtemps que nécessaire, à la tension et au courant permettant sa commutation. En outre, la consommation de la cellule mémoire lors d'une opération d'effacement est réduite. En outre, dans le présent mode de réalisation, la circulation de courant dans l'élément résistif R est interrompue après que la résistance de l'élément résistif R atteint une valeur de résistance déterminée pour laquelle le signal V_{COMP} passe de "0" à "1". On commande ainsi la résistance de l'élément résistif R après la commutation.

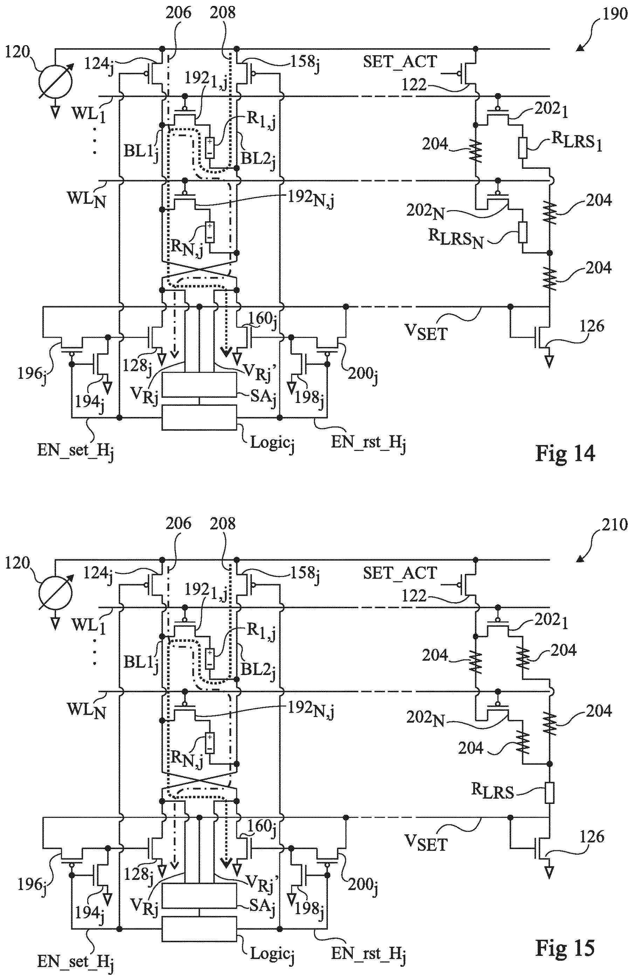

La figure 14 représente un mode de réalisation d'une mémoire 190 comprenant un dispositif d'écriture dont le fonctionnement peut être similaire à ce qui a été décrit précédemment pour le dispositif d'écriture 110 représenté en figure 11. La mémoire 190 comprend une matrice d'éléments résistifs R_{i,j} disposés sur N rangées et M colonnes, où i varie de 1 à N et j varie de 1 à M. En figure 14, on a représenté les éléments résistifs de la première rangée et de la dernière rangée pour la colonne "j". En outre, les éléments de la mémoire 190 identiques aux éléments des dispositifs d'écriture ou d'effacement décrits précédemment en relation avec les figures 11 à 13 sont désignés par les mêmes références auxquelles un indice peut être ajouté pour indiquer que l'élément est répété pour chaque rangée **"i"** et/ou pour chaque colonne "j".

A titre d'exemple, deux éléments résistifs R_{1,j} et R_{N},ⱼ de la colonne j sont représentés en figure 14. Chaque élément résistif R_{i,j} comprend une première borne (+) et une deuxième borne (-). La borne (+) est reliée à la source d'un transistor MOS 192_{i,j} à canal P. Pour chaque rangée "i", la grille de chaque transistor 192_{i,j} de la rangée est reliée à une ligne de mots WLᵢ. Pour chaque colonne "j", la source de chaque transistor 192_{i,j} de la colonne est reliée à une première ligne de bits BL1ⱼ et la borne (-) de chaque élément résistif R_{i,j} de la colonne est reliée à une deuxième ligne de bits BL2ⱼ. La ligne de bits BL1ⱼ est reliée au drain du transistor 124ⱼ et au drain du transistor 160ⱼ. La ligne de bits BL2ⱼ est reliée au drain du transistor 158ⱼ et au drain du transistor 128ⱼ.

La mémoire 190 comprend un circuit de détection de fin d'écriture et/ou d'effacement SAⱼ qui est relié aux lignes de bits BL1ⱼ et BL2ⱼ et à la grille du transistor 126. Le fonctionnement du circuit SAⱼ peut être analogue à celui du circuit de détection de fin d'écriture 116 ou 174 décrit précédemment. La mémoire 190 comprend un circuit logique Logicⱼ qui est relié au circuit SAⱼ et qui fournit les signaux EN_set_Hⱼ et EN_rst_Hⱼ. Le fonctionnement du circuit Logicⱼ peut être analogue à celui du circuit logique 118 ou 176 décrit précédemment.

La mémoire 190 comprend, en outre, un transistor MOS 194ⱼ à canal N dont la source est reliée à la masse GND, dont le drain est relié à la grille du transistor 128ⱼ et dont la grille reçoit le signal EN_set_Hⱼ. La mémoire 190 comprend, en outre, un transistor MOS 196ⱼ à canal P dont la source est reliée à la grille du transistor 126, dont le drain est relié à la grille du transistor 128ⱼ et dont la grille reçoit le signal EN_set_Hⱼ. La mémoire 190 comprend, en outre, un transistor MOS 198ⱼ à canal N dont la source est reliée à la masse GND, dont le drain est relié à la grille du transistor 160ⱼ et dont la grille reçoit le signal EN_rst_Hⱼ. La mémoire 190 comprend, en outre, un transistor MOS 200ⱼ à canal P dont la source est reliée à la grille du transistor 126, dont le drain est relié à la grille du transistor 160ⱼ et dont la grille reçoit le signal EN_rst_Hⱼ.

Dans le mode de réalisation représenté en figure 14, une résistance de référence R_{LRSi} et un transistor MOS 202ᵢ à canal P sont prévus pour chaque rangée "i". La grille du transistor 202ᵢ est reliée à la ligne de mots WLᵢ et le drain du transistor 202ᵢ est relié à une première borne de la résistance R_{LRSi}. Pour la première rangée, la source du transistor 202₁ est reliée au drain du transistor 122. Pour les autres rangées, la source du transistor 202ᵢ de la rangée est reliée à la source du transistor 202ᵢ₋₁ de la rangée précédente. Pour la dernière rangée, la deuxième borne de la résistance R_{LRSN} est reliée au drain du transistor 126. Pour les autres rangées, la deuxième borne de la résistance R_{LRSi} est reliée à la deuxième borne de la résistance R_{LRSi+1} de la rangée suivante. On a représenté en figure 14 des résistances parasites 204 qui sont sensiblement réparties de façon homogène sur les pistes conductrices reliant les interrupteurs 202ᵢ.

Le fonctionnement de la mémoire 190 est le suivant. L'élément résistif R_{i,j} dans laquelle une opération d'écriture ou d'effacement doit être réalisée est sélectionné par la mise à la masse de la ligne de mots WLᵢ de façon que le transistor 192_{i,j} devienne passant, les autres lignes de mots étant maintenues au potentiel haut VDD. En outre, le transistor 122 est passant de sorte qu'un courant circule dans la résistance R_{LRSi} de la même rangée que l'élément résistif R_{i,j} sélectionné.

Pour une opération d'écriture dans l'élément résistif R_{i,j} de la colonne "j", le signal EN_set_Hⱼ est mis à "0" et le signal EN_rst_Hⱼ est mis à "1". Le transistor 196ⱼ est donc passant et le transistor 194ⱼ est bloqué. Un courant peut donc circuler au travers du transistor 128ⱼ. Le transistor 198ⱼ est passant et le transistor 200ⱼ est bloqué. Le transistor 160ⱼ est donc bloqué et aucun courant ne peut le traverser. De ce fait, lors de l'opération d'écriture, un courant traverse successivement le transistor 124ⱼ, le transistor 192_{i,j}, l'élément résistif R_{i,j}, de la borne (+) vers la borne (-), et le transistor 128ⱼ. Le parcours du courant est représenté par une ligne 206 tiretée.

Pour une opération d'effacement dans l'élément résistif R_{i,j} de la colonne "j", le signal EN_set_Hⱼ est mis à "1" et le signal EN_rst_Hⱼ est mis à "0". Le transistor 200ⱼ est donc passant et le transistor 198ⱼ est bloqué. Un courant peut donc circuler au travers du transistor 160ⱼ. Le transistor 194ⱼ est passant et le transistor 196ⱼ est bloqué. Le transistor 128ⱼ est donc bloqué et aucun courant ne peut le traverser. De ce fait, lors de l'opération d'effacement, un courant traverse successivement le transistor 158ⱼ, l'élément résistif R_{i,j}, de la borne (-) vers la borne (+), le transistor 192_{i,j}, et le transistor 160ⱼ. Le parcours du courant est représenté par une ligne 208 en pointillé.

L'agencement des résistances R_{LRSi} fait que les résistances parasites vues par le courant I_{LRS} traversant la résistance R_{LRSi} sont sensiblement les mêmes quel que soit l'élément résistif R_{i,j} sélectionné.

La figure 15 représente un autre mode de réalisation d'une mémoire 210. La mémoire 210 comprend l'ensemble des éléments de la mémoire 190 à la différence qu'une seule résistance R_{LRS} est présente et est utilisée quel que soit l'élément résistif R_{i,j} sélectionné. On a donc, de façon avantageuse, un gain en surface par rapport à la mémoire 190 et moins de variabilité sur le courant I_{LRS} puisque la même résistance R_{LRS} est utilisée. En outre, les résistances parasites vues par le courant I_{LRS} traversant la résistance R_{LRS} sont sensiblement les mêmes quel que soit l'élément résistif R_{i,j} sélectionné.

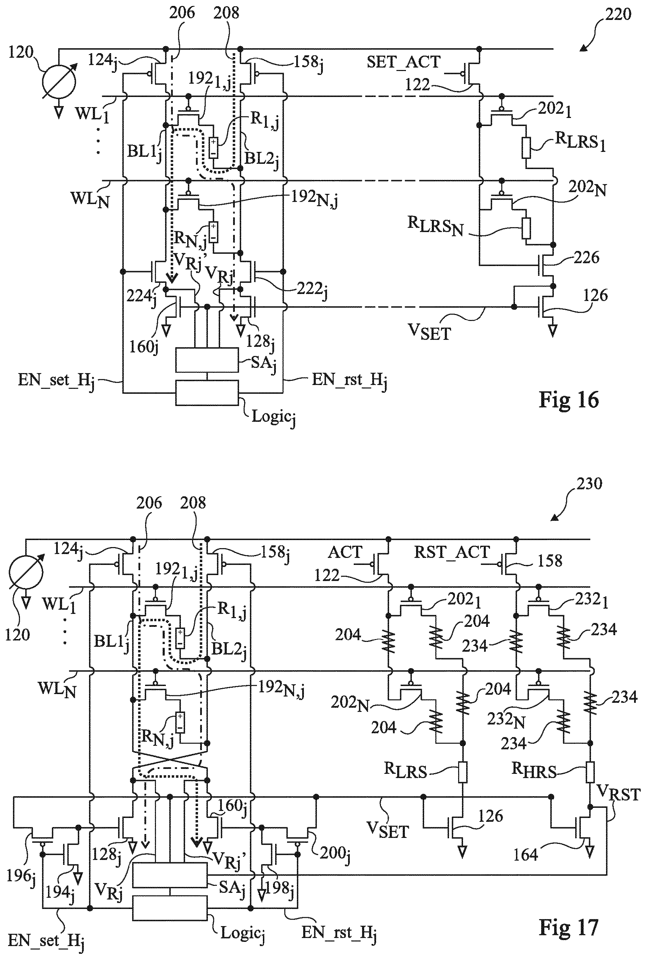

La figure 16 représente un autre mode de réalisation d'une mémoire 220. La mémoire 220 comprend l'ensemble des éléments de la mémoire 190 à la différence que les transistors 194ⱼ, 196ⱼ, 198ⱼ et 200ⱼ ne sont pas présents. La mémoire 220 comprend un transistor MOS 222ⱼ à canal N dont la source est reliée au drain du transistor 128ⱼ et au circuit SAⱼ, dont le drain est relié à la ligne BL2ⱼ et dont la grille reçoit le signal EN_rst_Hⱼ. La mémoire 220 comprend un transistor MOS 224ⱼ à canal N dont la source est reliée au drain du transistor 160ⱼ et au circuit SAⱼ, dont le drain est relié à la ligne BL1ⱼ et dont la grille reçoit le signal EN_set_Hⱼ. La mémoire 220 comprend, en outre, un transistor MOS 226 à canal N dont la source est reliée au drain du transistor 126, dont le drain est relié à une borne de chaque résistance R_{LRSi} et dont la grille est reliée au drain du transistor 122.

Pour une opération d'écriture dans l'élément résistif R_{i,j} de la colonne "j", le signal EN_set_Hⱼ est mis à "0" et le signal EN_rst_Hⱼ est mis à "1". Le transistor 222ⱼ est donc passant et le transistor 224ⱼ est bloqué. De ce fait, le courant circule comme cela est représenté par la ligne 206 tiretée. Pour une opération d'effacement dans l'élément résistif R_{i,j} de la colonne "j", le signal EN_set_Hⱼ est mis à "1" et le signal EN_rst_Hⱼ est mis à "0". Le transistor 224ⱼ est donc passant et le transistor 222ⱼ est bloqué. De ce fait, le courant circule comme cela est représenté par la ligne 208 en pointillé.

Dans le mode de réalisation représenté en figure 16, la mémoire 220 a, de façon avantageuse, une structure simplifiée, avec un nombre réduit de transistors, par rapport à la mémoire 190.

La figure 17 représente un autre mode de réalisation d'une mémoire 230 dans lequel le dispositif d'effacement 170 décrit précédemment en relation avec la figure 13 peut être mis en oeuvre. La mémoire 230 a la même structure que la mémoire 210 représentée en figure 15. La mémoire 230 comprend, en outre, pour chaque rangée, un transistor MOS à canal P 232ᵢ dont la grille est reliée à la ligne de mots WLᵢ. Pour la première rangée, la source du transistor 232₁ est reliée au drain du transistor 158. Pour les autres rangées, la source du transistor 232ᵢ de la rangée est reliée à la source du transistor 232ᵢ₋₁ de la rangée précédente. Pour la dernière rangée, le drain du transistor 232_{N} est relié à une borne de la résistance R_{HRS}. Pour les autres rangées, le drain du transistor 232ᵢ de la rangée est relié au drain du transistor 232ᵢ₊₁ de la rangée suivante. On a représenté en figure 17 des résistances parasites 234 qui sont sensiblement réparties de façon homogène sur les pistes conductrices reliant les interrupteurs 232ᵢ. Bien entendu, on peut prévoir une résistance R_{HRS} pour chaque rangée de manière analogue à ce qui a été décrit pour les résistances R_{LRSi} en figure 16. Le circuit de détection SAⱼ est, en outre, relié au drain du transistor 164. Le fonctionnement du circuit SAⱼ peut être analogue à celui du circuit de détection de fin d'écriture 156 décrit précédemment.

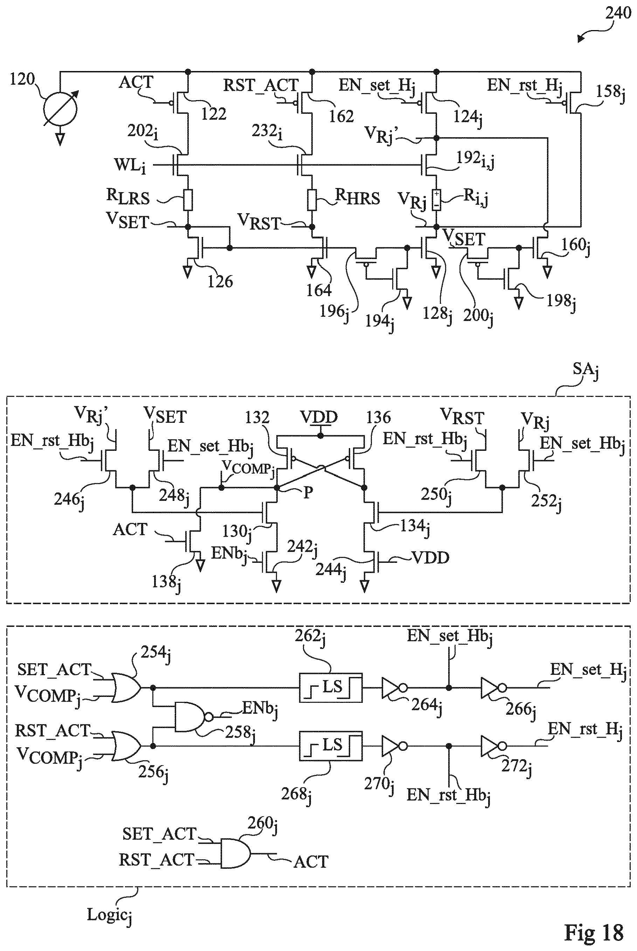

La figure 18 représente un mode de réalisation plus détaillé d'un dispositif d'écriture et d'effacement 240 adapté à être mis en oeuvre avec la mémoire 230 de la figure 17. Les éléments communs avec le dispositif d'écriture 110 représenté en figure 11 et le dispositif d'effacement 150 représenté en figure 12 sont désignés par les mêmes références auxquelles un indice peut être ajouté pour indiquer que l'élément est répété pour chaque rangée "i" et/ou pour chaque colonne "j".

La grille du transistor 122 reçoit un signal ACT et la grille du transistor 162 reçoit le signal RST_ACT.

Le circuit de détection de fin d'écriture et/ou d'effacement SAⱼ comprend l'ensemble des éléments du circuit 154 à la différence que le transistor 140 est remplacé par deux transistors MOS 242ⱼ, 244j à canal N. Le drain du transistor 242ⱼ est relié à la source du transistor 130ⱼ. La source du transistor 242ⱼ est reliée à la masse GND et la grille du transistor 242ⱼ reçoit le signal ENbⱼ. Le drain du transistor 244ⱼ est relié à la source du transistor 134ⱼ. La source du transistor 244ⱼ est reliée à la masse GND et la grille du transistor 244ⱼ reçoit le potentiel de référence haut VDD. Le transistor 244ⱼ est donc passant.

Le circuit SAⱼ comprend, en outre, un transistor MOS 246ⱼ à canal N dont le drain reçoit le signal V_{Rj}' et dont la grille reçoit le signal EN_rst_Hbⱼ. Le circuit SAⱼ comprend, en outre, un transistor MOS 248ⱼ à canal N dont le drain reçoit le signal V_{SET} et dont la grille reçoit le signal EN_set_Hbⱼ. Les sources des transistors 246ⱼ et 248ⱼ sont reliées à la grille du transistor 130ⱼ. Le circuit SAⱼ comprend, en outre, un transistor MOS 250ⱼ à canal N dont le drain reçoit le signal V_{RST} et dont la grille reçoit le signal EN_rst_Hbⱼ. Le circuit SAⱼ comprend, en outre, un transistor MOS 252ⱼ à canal N dont le drain reçoit le signal V_{Rj} et dont la grille reçoit le signal EN_set_Hbⱼ. Les sources des transistors 250ⱼ et 252ⱼ sont reliées à la grille du transistor 134ⱼ.

La commande des opérations d'écriture et de lecture est effectuée par les signaux binaires SET_ACT et RST_ACT. Le circuit logique Logicⱼ comprend quatre blocs logiques 254ⱼ, 256ⱼ, 258ⱼ et 260ⱼ. Le bloc 254ⱼ réalise la fonction logique "OU" et reçoit les signaux SET_ACT et V_{COMPj}. Le bloc 256ⱼ réalise la fonction logique "OU" et reçoit les signaux RST_ACT et V_{COMPj}. Le bloc 258ⱼ réalise la fonction logique "NON ET", reçoit les sorties des blocs 254ⱼ et 256ⱼ et fournit le signal ENbⱼ. Le bloc 260ⱼ réalise la fonction logique "ET", reçoit les signaux SET_ACT et RST_ACT et fournit le signal ACT.

Le circuit logique Logicⱼ comprend un circuit de conversion de niveau 262ⱼ recevant la sortie du bloc 254ⱼ. La sortie du circuit de conversion de niveau 262ⱼ attaque un inverseur 264ⱼ qui fournit le signal EN_set_Hby. Le signal EN_set_Hbⱼ attaque un inverseur 266ⱼ qui fournit le signal EN_set_Hⱼ. Le circuit logique Logicⱼ comprend un circuit de conversion de niveau 268ⱼ recevant la sortie du bloc 256ⱼ. La sortie du circuit de conversion de niveau 268ⱼ attaque un inverseur 270ⱼ qui fournit le signal EN_rst_Hbⱼ. Le signal EN_rst_Hbⱼ attaque un inverseur 272ⱼ qui fournit le signal EN_rst_Hⱼ.

Les signaux SET_ACT et RST_ACT sont à "1" par défaut. Le signal ACT est donc à "1". Le transistor 138 est donc passant, ce qui maintient le signal V_{COMPj} à "0". En outre, les transistors 122, 162 sont bloqués. Aucun courant ne circule dans les résistances R_{LRS} et R_{HRS}. Le signal ENbⱼ est à "0". Le transistor 242ⱼ est donc bloqué. Les signaux EN_set_Hbⱼ et EN_rst_Hbⱼ sont à "0". Les transistors 246ⱼ, 248ⱼ, 250ⱼ et 252ⱼ sont donc bloqués. Les signaux EN_set_Hⱼ et EN_rst_Hⱼ sont à "1", les transistors 124ⱼ et 158ⱼ sont donc bloqués. Aucun courant ne circule dans l'élément résistif R_{i,j}. Les signaux SET_ACT et RST_ACT sont identiques pour toutes colonnes de la matrice.

Pour réaliser une opération d'écriture dans l'élément résistif R_{i,j} de la colonne "j", le signal SET_ACT est mis à "0", le signal RST_ACT restant à "1". Le signal ACT passe donc à "0". Le transistor 138ⱼ est donc bloqué et le transistor 122 devient passant. En outre, le signal ENbⱼ passe à "0". Le transistor 242ⱼ devient donc passant. Le signal EN_set_Hⱼ passe à "0". Le transistor 124ⱼ devient donc passant. Le signal EN_set_Hbⱼ passe à "1" tandis que le signal EN_rst_Hbⱼ, reste à "0". La grille du transistor 130ⱼ reçoit le signal V_{SET} et la grille du transistor 134ⱼ reçoit le signal V_{Rj}. Le circuit SAⱼ fonctionne alors comme le circuit de détection de fin d'écriture 116 décrit précédemment en relation avec la figure 11.

Pour réaliser une opération d'effacement dans l'élément résistif R_{i,j} de la colonne "j", le signal RST_ACT est mis à "0", le signal SET_ACT restant à "1". Le signal ACT passe donc à "0". Le transistor 138ⱼ est donc bloqué et le transistor 122 devient passant. En outre, le signal ENbⱼ passe à "0". Le transistor 242ⱼ devient donc passant. Le signal EN_rst_Hⱼ passe à "0". Le transistor 124ⱼ devient donc passant. Le signal EN_rst_Hbⱼ passe à "1" tandis que le signal EN_set_Hbⱼ reste à "0". La grille du transistor 130ⱼ reçoit le signal V_{Rj}' et la grille du transistor 134ⱼ reçoit le signal V_{RST}. Le circuit SAⱼ fonctionne alors comme le circuit de détection de fin d'effacement 154 décrit précédemment en relation avec la figure 12.

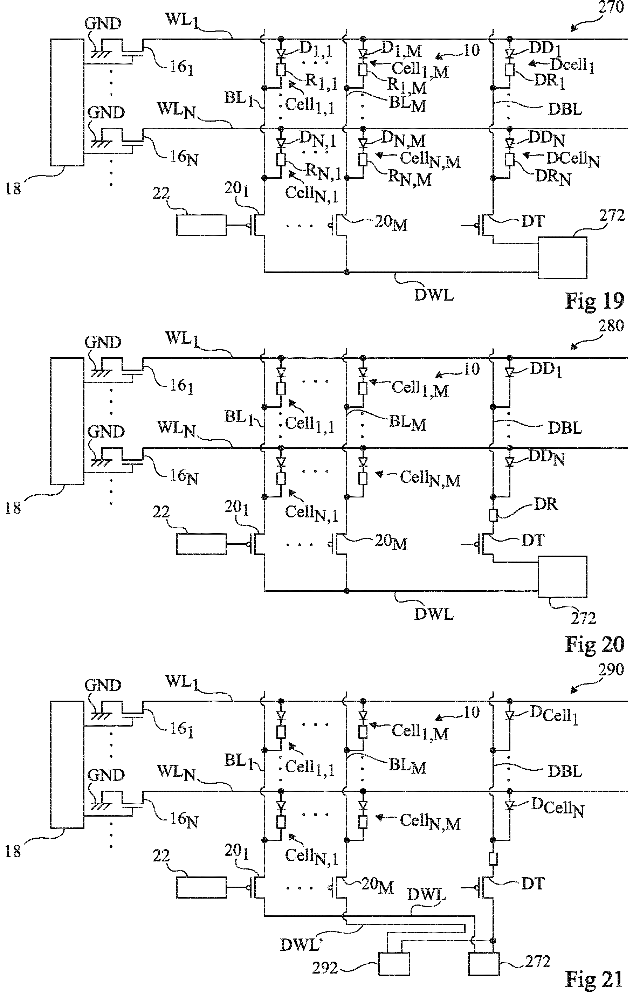

La figure 19 représente un autre mode de réalisation d'une mémoire 270. Les éléments communs avec la mémoire 5 représentée en figure 1 sont désignés par les mêmes références.

La mémoire 270 comprend notamment les cellules mémoires Cell_{i,j} réparties en rangées et en colonnes. Chaque ligne de bits BLⱼ, j variant de 1 à M, est reliée par l'intermédiaire de l'interrupteur 20ⱼ à une ligne de mots supplémentaire DWL. Une extrémité de la ligne de mots supplémentaire DWL est reliée à un dispositif d'effacement et/ou d'écriture 272. A titre d'exemple, chaque cellule mémoire Cellᵢ comprend un élément résistif de référence R_{i,j} en série avec un composant non linéaire, par exemple une diode D_{i,j}. La mémoire 270 comprend, en outre, une colonne supplémentaire de cellules de référence DCellᵢ, i variant de 1 à N. A titre d'exemple, chaque cellule de référence DCellᵢ peut avoir une structure analogue à celle de la cellule mémoire Cell_{i,j} et comprendre un élément résistif de référence DRᵢ en série avec un composant non linéaire, par exemple une diode DDᵢ. Chaque cellule de référence DCellᵢ comprend une première borne reliée à la ligne de mots WLᵢ et une deuxième borne reliée à une ligne de bits supplémentaire DBL. La ligne de bits supplémentaire DBL est reliée au dispositif d'effacement et/ou d'écriture 272 par l'intermédiaire d'un interrupteur DT commandé par le module 22 de sélection de lignes de bits. L'interrupteur DT correspond, par exemple, à un transistor MOS, par exemple à canal P, dont le drain est relié à la ligne de bits de référence DBL, dont la source est reliée à un noeud A' et dont la grille est commandée par le module 22.

A titre d'exemple, le dispositif 272 peut fonctionner de façon analogue au dispositif d'effacement 14 décrit précédemment en relation avec la figure 1, le circuit 32 étant alors remplacé par la ligne de bits supplémentaire DBL et les cellules de référence DCellᵢ. Selon un autre exemple, le dispositif 272 peut fonctionner de façon analogue au circuit de détection de fin d'écriture SAⱼ et au circuit logique de contre réaction Logicⱼ décrits précédemment en relation avec la figure 14. A titre d'exemple, pour réaliser une opération d'écriture et/ou d'effacement dans la cellule mémoire Cell_{i,j}, le dispositif 272 est adapté à :
faire circuler du courant dans la cellule de référence DCellᵢ et dans la cellule mémoire Cell_{i,j} ;
détecter le basculement de la résistance de la cellule mémoire Cell_{i,j}, par exemple en comparant des tensions représentatives de la tension aux bornes de la cellule de référence DCellᵢ et de la tension aux bornes de la cellule mémoire Cell_{i,j} ; et
à interrompre le courant traversant la cellule mémoire Cell_{i,j} à la détection du basculement.

Lors de l'opération d'écriture et/ou d'effacement, du courant circule dans la cellule mémoire sélectionnée Cell_{i,j} en passant par la partie de la ligne de mots WLᵢ entre l'interrupteur 16ᵢ et la cellule mémoire Cell_{i,j}, la partie de la ligne de bits BLⱼ entre la cellule mémoire Cell_{i,j} et l'interrupteur 20ⱼ et la partie de la ligne de mots supplémentaire entre l'interrupteur 2Cⱼ et le dispositif 272. En outre, du courant circule dans la cellule de référence DCellᵢ en passant par la partie de la ligne de mots WLᵢ entre l'interrupteur 16ᵢ et la cellule de référence DCellᵢ et la partie de la ligne de bits supplémentaire DBL entre la cellule de référence DCellᵢ et l'interrupteur DT qui est relié directement au dispositif 272. De ce fait, les résistances parasites vues par le courant traversant la cellule mémoire Cell_{i,j} sont sensiblement les mêmes que les résistances parasites vues par le courant traversant la cellule de référence DCellᵢ.

La figure 20 représente un autre mode de réalisation d'une mémoire 280. La mémoire 280 comprend l'ensemble des éléments de la mémoire 270 à la différence que les éléments résistifs de référence DRᵢ sont remplacés par une seule résistance DR présente à la base de la ligne de bits supplémentaire DBL et qui est utilisée quelle que soit la cellule mémoire Cell_{i,j} sélectionnée. On a donc, de façon avantageuse, un gain en surface par rapport à la mémoire 270 et moins de variabilité sur le courant puisque la même résistance DR est utilisée.

La figure 21 représente un autre mode de réalisation d'une mémoire 290. La mémoire 290 comprend l'ensemble des éléments de la mémoire 280 à la différence que certaines lignes de bits BLᵢ ne sont pas reliées à la ligne de mots supplémentaire DWL mais sont reliées à une deuxième ligne de mots supplémentaire DWL' par l'intermédiaire de l'interrupteur 20ⱼ. Une extrémité de la deuxième ligne de mots supplémentaire DWL' est reliée à un dispositif d'effacement et/ou d'écriture 292, par exemple identique au dispositif 272, auquel est reliée également la ligne de bits supplémentaire DBL. Ce mode de réalisation permet l'écriture/l'effacement simultané de cellules mémoires de différentes colonnes. La deuxième ligne de mots supplémentaire DWL' est disposée de façon que les résistances parasites vues par le courant traversant la cellule mémoire Cell_{i,j} reliée au dispositif 292 soient sensiblement les mêmes que les résistances parasites vues par le courant traversant la résistance DR reliée au dispositif 292.

Des modes de réalisation particuliers ont été décrits. Diverses variantes et modifications apparaîtront à l'homme de l'art. En particulier, les transistors MOS à canal N peuvent être remplacés par des transistors MOS à canal P et les transistors MOS à canal P peuvent être remplacés par des transistors MOS à canal N en adaptant les signaux de commande de ces transistors.

En outre, bien que les modes de réalisation décrits précédemment concernent des cellules mémoires bipolaires pour lesquelles la polarité de la tension appliquée aux bornes de la cellule mémoire est inversée entre une opération d'écriture et une opération d'effacement, il est clair que ces modes de réalisation peuvent être adaptés à des cellules mémoires unipolaires pour lesquelles la polarité de la tension appliquée aux bornes de la cellule mémoire est la même pour une opération d'écriture et une opération d'effacement, seule la plage d'amplitude de la tension appliquée étant différente entre une opération d'écriture et une opération d'effacement.

En outre, bien que dans les modes de réalisation décrits précédemment en relation avec les figures 11 à 18, chaque cellule mémoire comprenne un élément résistif en série avec un interrupteur, notamment un transistor MOS, ces modes de réalisation peuvent être mis en oeuvre avec d'autres types de cellules mémoires. A titre d'exemple, chaque cellule mémoire peut comprendre une diode en série avec l'élément résistif.

## Revendications

1. Mémoire résistive (5 ; 190 ; 210 ; 220 ; 230) comprenant :
des éléments résistifs (R_{i,j}) agencés en rangées et en colonnes, la résistance de chaque élément résistif pouvant alterner entre une valeur haute dans une première plage de valeurs et une valeur basse dans une deuxième plage de valeurs strictement inférieure à la valeur haute ;
pour chaque rangée, au moins une première piste conductrice de rangée (WLᵢ) ;
pour chaque élément résistif (R_{i,j}), un premier interrupteur (192_{i,j}), la première piste conductrice de rangée (WLᵢ) étant reliée à chaque premier interrupteur de la rangée ;
pour chaque colonne, une première piste conductrice de colonne (BL2ⱼ) et une deuxième piste conductrice de colonne (BL1ⱼ), chaque élément résistif (R_{i,j}) étant en série avec le premier interrupteur associé entre la deuxième piste conductrice de colonne et la première piste conductrice de colonne ;
au moins une première piste conductrice de référence de colonne reliée à au moins un premier composant résistif de référence (R_{LRS} ; R_{HRS} ; DCellᵢ) ;
la mémoire comprenant, en outre, un dispositif (14 ; 90) de basculement de la résistance d'au moins un élément résistif sélectionné parmi les éléments résistifs entre les valeurs haute et basse, le dispositif comprenant des premier, deuxième, troisième, et quatrième circuits,
le premier circuit étant adapté à appliquer une première tension aux bornes du premier composant résistif de référence, le deuxième circuit étant adapté, pendant une opération de basculement, à appliquer une deuxième tension proportionnelle à la première tension aux bornes de l'élément résistif sélectionné, et le quatrième circuit étant adapté à interrompre la deuxième tension à la détection du basculement ; ou
le premier circuit étant adapté à faire circuler un premier courant dans le premier composant résistif de référence (R_{LRS} ; R_{HRS}), le deuxième circuit étant adapté, pendant une opération de basculement, à faire circuler un deuxième courant proportionnel au premier courant dans l'élément résistif sélectionné, et le quatrième circuit étant adapté à interrompre le deuxième courant traversant l'élément résistif sélectionné à la détection du basculement,
et dans lequel le troisième circuit est adapté à détecter le basculement de la résistance de l'élément résistif sélectionné à partir de la comparaison d'une troisième tension (V_{SET} ; V_{RST}) qui dépend de la tension aux bornes du premier composant résistif de référence et d'une quatrième tension (V_{R}) qui dépend de la tension aux bornes de l'élément résistif sélectionné,
**caractérisé en ce que** pour chaque rangée, un deuxième interrupteur (202i) relié à la première piste conductrice de rangée et au premier composant résistif de référence (RLRS ; RHRS); et une deuxième piste conductrice de référence de colonne, chaque deuxième interrupteur (202i) étant interposé entre la première piste conductrice de référence de colonne et la deuxième piste conductrice de référence de colonne.

2. Mémoire résistive selon la revendication 1, dans laquelle le premier circuit est adapté à faire circuler un cinquième courant proportionnel au premier courant dans au moins un deuxième composant résistif de référence (R_{LRS}).

3. Mémoire résistive selon la revendication 2, comprenant un miroir de courant adapté à fournir, dans ledit élément résistif (R_{i,j}) sélectionné, le premier courant circulant dans le premier composant résistif de référence (R_{LRS} ; R_{HRS}) éventuellement multiplié par un facteur multiplicatif, ou le cinquième courant circulant dans le deuxième composant résistif de référence (R_{LRS}) éventuellement multiplié par un facteur multiplicatif.

4. Mémoire résistive selon l'une quelconque des revendications 1 à 3, dans laquelle le premier circuit est adapté à fournir la première tension (Vref) croissante, et dans laquelle le dispositif (14) comprend un circuit (30) de fourniture d'une troisième tension (VRamp) croissante et un diviseur de tension comprenant en série au moins un composant résistif (Rm ; 72 ; 78 ; 96) et l'élément résistif sélectionné, la troisième tension étant appliquée entre les bornes du diviseur de tension, la quatrième tension (Vrm ; Vrm') étant mesurée à un noeud (C) du diviseur de tension entre le composant résistif et l'élément résistif sélectionné.

5. Mémoire résistive selon la revendication 3, dans laquelle, pour chaque colonne, les première et deuxième pistes conductrices de colonne (BL1ⱼ, BL2ⱼ) sont reliées au miroir de courant et dans laquelle la première piste conductrice de référence de colonne est reliée au miroir de courant.

6. Mémoire résistive selon l'une quelconque des revendications 1 à 5, comprenant un circuit (120) de fourniture d'une tension de référence (VProg) relié, pour chaque colonne, à la première piste conductrice de colonne (BL1ⱼ) par un troisième interrupteur (124ⱼ) et à la deuxième piste conductrice de colonne (BL2ⱼ) par un quatrième interrupteur (158ⱼ) et relié à la deuxième piste conductrice de référence de colonne par un cinquième interrupteur (122).

7. Mémoire résistive selon l'une quelconque des revendications 1 à 6, comprenant, pour chaque rangée, ledit premier composant résistif de référence (R_{LRS} ; R_{HRS}) en série avec le deuxième interrupteur (202ᵢ), la deuxième piste conductrice de référence de colonne étant reliée, pour chaque rangée, au deuxième interrupteur de la rangée et la première piste conductrice de référence de colonne étant reliée, pour chaque rangée, au premier composant résistif de référence de la rangée.

8. Mémoire résistive selon l'une quelconque des revendications 1 à 6, comprenant un unique premier composant résistif de référence (R_{LRS} ; R_{HRS}), les première et deuxième pistes conductrices de référence de colonne étant reliées, pour chaque rangée, au deuxième interrupteur (202i) de la rangée et la première piste conductrice de référence de colonne étant reliée au premier composant résistif de référence unique.

9. Mémoire résistive selon la revendication 2, comprenant, en outre, des troisième et quatrième pistes conductrices de référence de colonne, et pour chaque rangée, un troisième interrupteur (232ᵢ) reliant les troisième et quatrième pistes conductrices de référence de colonne, la troisième et/ou la quatrième piste conductrice de référence de colonne étant reliée au deuxième composant résistif de référence (R_{LRS} ; R_{HRS}).

10. Procédé de commande d'une mémoire résistive (190 ; 210 ; 220 ; 230) comprenant :
des éléments résistifs (R_{i,j}) agencés en rangées et en colonnes, la résistance de chaque élément résistif pouvant alterner entre une valeur haute dans une première plage de valeurs et une valeur basse dans une deuxième plage de valeurs strictement inférieure à la valeur haute ;
pour chaque rangée, au moins une première piste conductrice de rangée (WLᵢ) ;
pour chaque élément résistif (R_{i,j}), un premier interrupteur (192_{i,j}) en série avec l'élément résistif, la première piste conductrice de rangée (WLᵢ) étant reliée à chaque premier interrupteur de la rangée ;
pour chaque colonne, une première piste conductrice de colonne (BL2ⱼ) et une deuxième piste conductrice de colonne (BL1ⱼ), chaque élément résistif (R_{i,j}) étant en série avec le premier interrupteur associé entre la deuxième piste conductrice de colonne et la première piste conductrice de colonne ;
au moins une première piste conductrice de référence de colonne reliée à au moins un premier composant résistif de référence (R_{LRS} ; R_{HRS} ; DCellᵢ) ;
pour chaque rangée, un deuxième interrupteur (202i) relié à la première piste conductrice de rangée et au premier composant résistif de référence (R_{LRS} ; R_{HRS}) ; et
une deuxième piste conductrice de référence de colonne, chaque deuxième interrupteur (202i) étant interposé entre la première piste conductrice de référence de colonne et la deuxième piste conductrice de référence de colonne,
le procédé comprenant les étapes a) ou b) suivantes pour le basculement de la résistance d'un élément résistif sélectionné parmi les éléments résistifs entre les valeurs haute et basse :
a) appliquer une première tension aux bornes du premier composant résistif de référence ; appliquer, pendant une opération de basculement, une deuxième tension proportionnelle à la première tension aux bornes de l'élément résistif sélectionné ; etinterrompre la deuxième tension à la détection du basculement ; ou
b)
faire circuler un premier courant dans le premier composant résistif de référence (R_{LRS} ; R_{HRS}) ; faire circuler, pendant une opération de basculement, un deuxième courant proportionnel au premier courant dans l'élément résistif sélectionné ; ; et interrompre le deuxième courant traversant l'élément résistif sélectionné,
et dans lequel le procédé comprend en outre l'étape suivante :
détecter le basculement de la résistance de l'élément résistif sélectionné à partir de la comparaison d'une troisième tension (V_{SET} ; V_{RST}) qui dépend de la tension aux bornes du premier composant résistif de référence et d'une quatrième tension (V_{R}) qui dépend de la tension aux bornes de l'élément résistif sélectionné.

11. Procédé de commande selon la revendication 10, dans lequel le premier courant est croissant pendant l'opération de basculement.

## Patentansprüche

1. Ein Widerstandsspeicher (5; 190; 210; 220; 230), der Folgendes aufweist:
Widerstandselemente (R_{i,j}), die in Reihen und Spalten angeordnet sind, wobei der Widerstand jedes Widerstandselements zwischen einem hohen Wert in einem ersten Wertebereich und einem niedrigen Wert in einem zweiten, gegenüber dem hohen Wert niedrigeren Wertebereich wechselbar ist;
für jede Reihe wenigstens eine erste Reihenleiterbahn (WLᵢ);
für jedes Widerstandselement (R_{i,j}) einen ersten Schalter (192_{i,j}), wobei die erste Reihenleiterbahn (WLᵢ) an jeden ersten Schalter in der Reihe gekoppelt ist;
für jede Spalte eine erste Spaltenleiterbahn (BL2ⱼ) und eine zweite Spaltenleiterbahn (BL1ⱼ), wobei jedes Widerstandselement (R_{i,j}) in Serie mit dem zugehörigen ersten Schalter zwischen der zweiten Spaltenleiterbahn und der ersten Spaltenleiterbahn liegt;
wenigstens eine erste Spalten-Referenzleiterbahn, die an wenigstens eine erste Referenzwiderstandskomponente (R_{LRS}; R_{HRS}; DCellᵢ) gekoppelt ist;
der Speicher ferner eine Einrichtung (14; 90) aufweist zum Umschalten des Widerstands wenigstens eines ausgewählten Widerstandselements aus den Widerstandselementen zwischen den hohen und niedrigen Werten, wobei die Einrichtung erste, zweite, dritte und vierte Schaltungen aufweist, die erste Schaltung eingerichtet zum Anlegen einer ersten Spannung an der ersten Referenzwiderstandskomponente, die zweite Schaltung eingerichtet, während einer Umschaltoperation, zum Anlegen einer zweiten, zur ersten Spannung proportionalen Spannung an dem ausgewählten Widerstandselement, und die vierte Schaltung eingerichtet zum Unterbrechen der zweiten Spannung bei Erkennung der Umschaltung; oder
die erste Schaltung eingerichtet zum Durchleiten eines ersten Stroms durch die erste Referenzwiderstandskomponente (R_{LRS}; R_{HRS}), die zweite Schaltung eingerichtet, während einer Umschaltoperation, zum Durchleiten eines zweiten, zum ersten Strom proportionalen Stroms durch das ausgewählte Widerstandselement, und die vierte Schaltung eingerichtet zum Unterbrechen des durch das ausgewählte Widerstandselement fließenden zweiten Stroms bei Erkennung der Umschaltung,
und wobei die dritte Schaltung eingerichtet ist zum Erkennen der Umschaltung des Widerstands des ausgewählten Widerstandselements basierend auf dem Vergleich einer dritten Spannung (V_{SET}; V_{RST}), die von der Spannung an der ersten Referenzwiderstandskomponente abhängt, mit einer vierten Spannung (V_{R}), die von der Spannung am ausgewählten Widerstandselement abhängt,
**gekennzeichnet dadurch, dass**, für jede Reihe ein zweiter Schalter (202ᵢ) vorhanden ist, der an die erste Reihenleiterbahn und an die erste Referenzwiderstandskomponente (R_{LRS}; R_{HRS}) gekoppelt ist; und eine zweite Spalten-Referenzleiterbahn vorhanden ist, wobei jeder zweite Schalter (202ᵢ) zwischen der ersten Spalten-Referenzleiterbahn und der zweiten Spalten-Referenzleiterbahn angeordnet ist.

2. Der Widerstandsspeicher nach Anspruch 1, wobei die erste Schaltung eingerichtet ist zum Durchleiten eines fünften Stroms, der zum ersten Strom proportional ist, durch wenigstens eine zweite Referenzwiderstandskomponente (R_{LRS}).

3. Der Widerstandsspeicher nach Anspruch 2, aufweisend einen Stromspiegel, der eingerichtet ist, in das ausgewählte Widerstandselement (R_{i,j}) den ersten Strom, der durch die erste Referenzwiderstandskomponente (R_{LRS}; R_{HRS}) fließt zu liefern, optional multipliziert mit einem Multiplikationsfaktor, oder den fünften Strom, der durch die zweite Referenzwiderstandskomponente (R_{LRS}) fließt zu liefern, optional multipliziert mit einem Multiplikationsfaktor.

4. Der Widerstandsspeicher nach einem der Ansprüche 1 bis 3, wobei die erste Schaltung eingerichtet ist zum Liefern der ersten ansteigenden Spannung (Vref), und wobei die Einrichtung (14) eine Schaltung (30) zum Liefern einer dritten ansteigenden Spannung (VRamp) und einen Spannungsteiler aufweist, der in Serie wenigstens eine Widerstandskomponente (Rm; 72; 78; 96) und das ausgewählte Widerstandselement enthält, wobei die dritte Spannung über den Spannungsteiler angelegt ist und die vierte Spannung (Vrm; Vrm') an einem Knoten (C) des Spannungsteilers gemessen wird, der zwischen der Widerstandskomponente und dem ausgewählten Widerstandselement liegt.

5. Der Widerstandsspeicher nach Anspruch 3, wobei für jede Spalte die erste und die zweite Spaltenleiterbahn (BL1ⱼ, BL2ⱼ) an den Stromspiegel gekoppelt sind und die erste Spalten-Referenzleiterbahn an den Stromspiegel gekoppelt ist.

6. Der Widerstandsspeicher nach einem der Ansprüche 1 bis 5, aufweisend eine Schaltung (120) zum Liefern einer Referenzspannung (VProg), die für jede Spalte durch einen dritten Schalter (124ⱼ) an die erste Spaltenleiterbahn (BL1ⱼ) und durch einen vierten Schalter (158ⱼ) an die zweite Spaltenleiterbahn (BL2ⱼ) gekoppelt ist und durch einen fünften Schalter (122) an die zweite Spalten-Referenzleiterbahn gekoppelt ist.

7. Der Widerstandsspeicher nach einem der Ansprüche 1 bis 6, aufweisend für jede Reihe die erste Referenzwiderstandskomponente (R_{LRS}; R_{HRS}), die in Serie mit dem zweiten Schalter (202ᵢ) ist, wobei die zweite Spalten-Referenzleiterbahn für jede Reihe an den zweiten Schalter in der Reihe gekoppelt ist und die erste Spalten-Referenzleiterbahn für jede Reihe an die erste Referenzwiderstandskomponente in der Reihe gekoppelt ist.

8. Der Widerstandsspeicher nach einem der Ansprüche 1 bis 6, aufweisend eine einzige erste Referenzwiderstandskomponente (R_{LRS}; R_{HRS}), wobei die erste und die zweite Spalten-Referenzleiterbahn für jede Reihe an den zweiten Schalter (202ᵢ) in der Reihe gekoppelt sind und die erste Spalten-Referenzleiterbahn an die einzige erste Referenzwiderstandskomponente gekoppelt ist.

9. Der Widerstandsspeicher nach Anspruch 2, aufweisend dritten und vierten Spalten-Referenzleiterbahnen und für jede Reihe, einen dritten Schalter (232ᵢ), die an die dritten und vierten Spalten-Referenzleiterbahnen gekoppelt ist, wobei die drei und/oder vier Spalten-Referenzleiterbahn an eine zweite Referenzwiderstandskomponente (R_{LRS}; R_{HRS}) gekoppelt ist.

10. Ein Verfahren zur Steuerung eines Widerstandsspeichers (190; 210; 220; 230), das Folgendes aufweist:
Widerstandselemente (R_{i,j}), die in Reihen und Spalten angeordnet sind,
wobei der Widerstand jedes Widerstandselements zwischen einem hohen Wert in einem ersten Wertebereich und einem niedrigen Wert in einem zweiten, gegenüber dem hohen Wert niedrigeren Wertebereich wechselbar ist;
für jede Reihe wenigstens eine erste Reihenleiterbahn (WLᵢ);
für jedes Widerstandselement (R_{i,j}) einen ersten Schalter (192_{i,j}), der in Serie mit dem Widerstandselement liegt, wobei die erste Reihenleiterbahn (WLᵢ) an jeden ersten Schalter in der Reihe gekoppelt ist;
für jede Spalte eine erste Spaltenleiterbahn (BL2ⱼ) und eine zweite Spaltenleiterbahn (BL1ⱼ), wobei jedes Widerstandselement (R_{i,j}) in Serie mit dem zugehörigen ersten Schalter zwischen der zweiten Spaltenleiterbahn und der ersten Spaltenleiterbahn liegt;
wenigstens eine erste Spalten-Referenzleiterbahn, die an wenigstens eine erste Referenzwiderstandskomponente (R_{LRS}; R_{HRS}; DCellᵢ) gekoppelt ist;
für jede Reihe einen zweiten Schalter (202ᵢ), der an die erste Reihenleiterbahn und an die erste Referenzwiderstandskomponente (R_{LRS}; R_{HRS}) gekoppelt ist; und
eine zweite Spalten-Referenzleiterbahn, wobei jeder zweite Schalter (202ᵢ) zwischen der ersten Spalten-Referenzleiterbahn und der zweiten Spalten-Referenzleiterbahn eingeschaltet ist,
wobei das Verfahren die folgenden Schritte a) oder b) für die Umschaltung des Widerstands eines ausgewählten Widerstandselements aus den Widerstandselementen zwischen den hohen und niedrigen Werten aufweist:
a) Anlegen einer ersten Spannung an der ersten Referenzwiderstandskomponente; Anlegen während einer Umschaltoperation einer zweiten, zur ersten Spannung proportionalen Spannung an dem ausgewählten Widerstandselement; und Unterbrechen der zweiten Spannung bei Erkennung der Umschaltung; oder
b) Durchleiten eines ersten Stroms durch die erste Referenzwiderstandskomponente (RLRS; RHRS); Durchleiten während einer Umschaltoperation eines zweiten, zum ersten Strom proportionalen Stroms durch das ausgewählte Widerstandselement; und Unterbrechen des durch das ausgewählte Widerstandselement fließenden zweiten Stroms,
und wobei das Verfahren ferner den Folgenden Schritt aufweist:
Erkennen der Umschaltung des Widerstands des ausgewählten Widerstandselements basierend auf dem Vergleich einer dritten Spannung (V_{SET}; V_{RST}), die von der Spannung an der ersten Referenzwiderstandskomponente abhängt, mit einer vierten Spannung (V_{R}), die von der Spannung am ausgewählten Widerstandselement abhängt.

11. Das Steuerungsverfahren nach Anspruch 10, wobei der erste Strom während der Umschaltoperation ansteigend ist.

## Claims

1. Resistive memory (5; 190; 210; 220; 230) comprising:
resistive elements (R_{i,j}) arranged in rows and columns, the resistance of each resistive element being capable of alternating between a high value in a first range of values and a low value in a second range of values lower than the high value;
for each row, at least one first row conductive track (WLᵢ);
for each resistive element (R_{i,j}), a first switch (192_{i,j}), the first row conductive track (WLᵢ) being coupled to each first switch in the row;
for each column, a first column conductive track (BL2ⱼ) and a second column conductive track (BL1ⱼ), each resistive element (R_{i,j}) being in series with the associated first switch between the second column conductive track and the first column conductive track;
at least one first column reference conductive track coupled to at least one first reference resistive component (R_{LRS}; R_{HRS}; DCellᵢ);
the memory further comprising a device (14; 90) for switching the resistance of at least one resistive element selected from among the resistive elements between the high and low values, the device comprising first, second, third, and fourth circuits,
the first circuit being adapted to applying a first voltage across the first reference resistive component, the second circuit being adapted, during a switching operation, to applying a second voltage proportional to the first voltage across the selected resistive element, and the fourth circuit being adapted to interrupting the second voltage upon detection of the switching; or
the first circuit being adapted to conducting a first current through the first reference resistive component (R_{LRS}; R_{HRS}), the second circuit being adapted, during a switching operation, to conducting a second current proportional to the first current through the selected resistive element, and the fourth circuit being adapted to interrupting the second current flowing through the selected resistive element upon detection of the switching,
and wherein the third circuit is adapted to detecting the switching of the resistance of the selected resistive element based on the comparison of a third voltage (V_{SET}; V_{RST}), which depends on the voltage across the first reference resistive component, with a fourth voltage (V_{R}), which depends on the voltage across the selected resistive element,
**characterized in that**, for each row, a second switch (202ᵢ) coupled to the first row conductive track and to the first reference resistive component (R_{LRS}; R_{HRS}); and a second column reference conductive track, each second switch (202ᵢ) being interposed between the first column reference conductive track and the second column reference conductive track.

2. Resistive memory according to claim 1, wherein the first circuit is adapted to conducting a fifth current, proportional to the first current, through at least one second resistive reference component (R_{LRS}).

3. Resistive memory according to claim 2, comprising a current mirror adapted to supplying, into said selected resistive element (R_{i,j}), the first current flowing through the first reference resistive component (R_{LRS}; R_{HRS}), optionally multiplied by a multiplication factor, or the fifth current flowing through the second reference resistive component (R_{LRS}), optionally multiplied by a multiplication factor.

4. Resistive memory according to any of claims 1 to 3, wherein the first circuit is adapted to delivering the first increasing voltage (Vref), and wherein the device (14) comprises a circuit (30) for delivering a third increasing voltage (VRamp) and a voltage divider comprising, in series, at least one resistive component (Rm; 72; 78; 96) and the selected resistive element, the third voltage being applied across the voltage divider, the fourth voltage (Vrm; Vrm') being measured at a node (C) of the voltage divider between the resistive component and the selected resistive element.

5. Resistive memory according to claim 3, wherein, for each column, the first and second column conductive tracks (BL1ⱼ, BL2ⱼ) are coupled to the current mirror, and wherein the first column reference conductive track is coupled to the current mirror.

6. Resistive memory according to any of claims 1 to 5, comprising a circuit (120) for delivering a reference voltage (VProg) coupled, for each column, to the first column conductive track (BL1ⱼ) by a third switch (124ⱼ) and to the second column conductive track (BL2ⱼ) by a fourth switch (158ⱼ), and coupled to the second column reference conductive track by a fifth switch (122).

7. Resistive memory according to any of claims 1 to 6, comprising, for each row, said first resistive reference component (R_{LRS}; R_{HRS}) in series with the second switch (202ᵢ), the second column reference conductive track being coupled, for each row, to the second switch in the row, and the first column reference conductive track being coupled, for each row, to the first reference resistive component in the row.

8. Resistive memory according to any of claims 1 to 6, comprising a single first reference resistive component (R_{LRS}; R_{HRS}), the first and second column reference conductive tracks being coupled, for each row, to the second switch (202ᵢ) in the row, and the first column reference conductive track being coupled to the single first reference resistive component.

9. Resistive memory according to claim 2, further comprising third and fourth column reference conductive tracks, and, for each row, a third switch (232ᵢ) coupling the third and fourth column reference conductive tracks, the third and/or fourth column reference conductive track being coupled to the second resistive reference component (R_{LRS}; R_{HRS}).

10. Method of controlling a resistive memory (190; 210; 220; 230) comprising:
resistive elements (R_{i,j}) arranged in rows and columns, the resistance of each resistive element being capable of alternating between a high value in a first range of values and a low value in a second range of values lower than the high value;
for each row, at least one first row conductive track (WLᵢ);
for each resistive element (R_{i,j}), a first switch (192_{i,j}) in series with the resistive element, the first row conductive track (WLᵢ) being coupled to each first switch in the row;
for each column, a first column conductive track (BL2ⱼ) and a second column conductive track (BL1ⱼ), each resistive element (R_{i,j}) being in series with the associated first switch between the second column conductive track and the first column conductive track;
at least one first column reference conductive track coupled to at least one first reference resistive component (R_{LRS}; R_{HRS}; DCellᵢ);
for each row, a second switch (202ᵢ) coupled to the first row conductive track and to the first reference resistive component (R_{LRS}; R_{HRS}); and
a second column reference conductive track, each second switch (202ᵢ) being interposed between the first column reference conductive track and the second column reference conductive track,
the method comprising the following steps a) or b) for the switching of the resistance of a resistive element selected from among the resistive elements between the high and low values:
a) applying a first voltage across the first reference resistive component; applying, during a switching operation, a second voltage proportional to the first voltage across the selected resistive element; and interrupting the second voltage upon detection of the switching; or
b) conducting a first current through the first reference resistive component (R_{LRS}; R_{HRS}); conducting, during a switching operation, a second current proportional to the first current through the selected resistive element; and interrupting the second current flowing through the selected resistive element,
and wherein the method further comprises the following step:
detecting the switching of the resistance of the selected resistive element based on the comparison of a third voltage (V_{SET}; V_{RST}), which depends on the voltage across the first reference resistive component, with a fourth voltage (V_{R}), which depends on the voltage across the selected resistive element.

11. Control method according to claim 10, wherein the first current is increasing during the switching operation.
